(19) Europäisches Patentamt
European Patent Office
Office européen des brevets

(11) **EP 1 388 123 B1**

(12) **EUROPEAN PATENT SPECIFICATION**

(45) Date of publication and mention
of the grant of the patent:
**03.09.2008 Bulletin 2008/36**

(21) Application number: **02706925.1**

(22) Date of filing: **13.03.2002**

(51) Int Cl.:
**G06N 3/12** (2006.01)

(86) International application number:
**PCT/GB2002/001157**

(87) International publication number:
**WO 2002/075650 (26.09.2002 Gazette 2002/39)**

(54) **HARDWARE DESIGN USING EVOLUTION ALGORITHMS**

HARDWARE-ENTWURF UNTER BENUTZUNG VON EVOLUTIONÄREN ALGORITHMEN

CONCEPTION DE MATERIEL AU MOYEN D'ALGORITHMES D'EVOLUTION

(84) Designated Contracting States:
**AT BE CH CY DE DK ES FI FR GB GR IE IT LI LU MC NL PT SE TR**

(30) Priority: **15.03.2001 GB 0106459**

(43) Date of publication of application:
**11.02.2004 Bulletin 2004/07**

(73) Proprietor: **Ericsson AB
Stockholm (SE)**

(72) Inventors:
• **YAO, Xin
Edgbaston,
Birmingham B15 3NT (GB)**
• **SCHNIER, Thorsten
Selly Oak,
Birmingham B29 6RP (GB)**

(74) Representative: **Stasiewski, Piotr Grzegorz et al
Ericsson Limited
Intellectual Property Group
Maplewood
Chineham Business Park
Basingstoke
Hampshire RG24 8YB (GB)**

(56) References cited:
**EP-A- 0 657 832**          **US-A- 5 867 397**

• ZITZLER E ET AL: "Multiobjective evolutionary algorithms: a comparative case study and the strength Pareto approach" IEEE TRANSACTIONS ON EVOLUTIONARY COMPUTATION, NOV. 1999, IEEE, USA, vol. 3, no. 4, pages 257-271, XP002252371 ISSN: 1089-778X
• SCHNIER T ET AL: "Digital filter design using multiple Pareto fronts" PROCEEDINGS THIRD NASA/DOD WORKSHOP ON EVOLVABLE HARDWARE. EH-2001, PROCEEDINGS THIRD NASA/DOD WORKSHOP ON EVOLVABLE HARDWARE. EH-2001, LONG BEACH, CA, USA, 12-14 JULY 2001, pages 136-145, XP002252372 2001, Los Alamitos, CA, USA, IEEE Comput. Soc, USA ISBN: 0-7695-1180-5
• LEE A ET AL: "Digital filter design using genetic algorithm" ADVANCES IN DIGITAL FILTERING AND SIGNAL PROCESSING, 1998 IEEE SYMPOSIUM ON VICTORIA, BC, CANADA 5-6 JUNE 1998, NEW YORK, NY, USA,IEEE, US, 5 June 1998 (1998-06-05), pages 34-38, XP010289015 ISBN: 0-7803-4957-1

EP 1 388 123 B1

**Description**

This invention relates to evolvable hardware, and the design of hardware architectures and structures using evolvable hardware.

Evolvable hardware (EHW) refers to one particular type of hardware whose architecture/structure and functions change dynamically and autonomously in order to improve its performance in performing certain tasks. Evolvable hardware is discussed in an article by X. Yao entitled "Following the path of evolvable hardware", Communications of the ACM, vol. 42, no. 4, pp. 47-49 1999; and in an article by X. Yao and T. Higuchi entitled "Promises and challenges of evolvable hardware" IEEE Trans. On Systems, Man, and Cybernetics, Part C: Applications and reviews, vol. 29, no. 1, pp. 87-97, 1999.

The emergence of this new field in recent years has been influenced profoundly by the progresses in reconfigurable hardware and evolutionary computation. Traditional hardware is notorious for its inflexibility. It is impossible to change the hardware structure and its functions once it is made. However, most real world problems are not fixed. They change with time. In order to deal with these problems efficiently and effectively, different hardware structures are necessary. EHW provides an ideal approach to make hardware "soft" by adapting the hardware structure to a problem dynamically.

EHW may be described as applications of evolutionary computation techniques to electronic hardware design, e.g., filter design; or hardware which is capable of on-line adaptation through reconfiguring its architecture dynamically and autonomously. The former emphasizes evolutionary computation techniques as potential design tools, while the later emphasizes adaptation of hardware. It is worth pointing out that EHW is quite different from the hardware implementation of evolutionary algorithms, where hardware is used to speed up various evolutionary operations. The hardware itself does not change or adapt.

There are two major aspects to EHW: simulated evolution and electronic hardware. The simulated evolution can be driven by genetic algorithms (Gas), genetic programming (GP), evolutionary programming (EP) , or evolution strategies (Ess). There is no uniform answer as to which type of evolutionary algorithm would be the best for EHW. Different evolutionary algorithms (EAs) would suit different EHW. The electronic hardware used in EHW can be digital, analogue or hybrid circuits. One of the advantages of Eas is that they impose very few constraints on the type of circuits used in EHW.

Most EHW relies heavily on reconfigurable hardware, such as field programmable gate arrays (FPGAs). The architecture and functionality of an FPGA are determined directly by its architecture bits. These bits are reconfigurable. EHW makes use of this flexibility and employs an EA to evolve these bits in order to perform certain tasks effectively and efficiently.

The most general definition of Evolvable Hardware is "the design of hardware (usually electronic, but also mechanical, biological, chemical) by means of an evolutionary algorithm". There are many different types of evolutionary algorithms, all of them used in EHW, but they are all based on generate-and-test, combined with the idea of "survival of the fittest". In general, a population of individuals (designs in this case) is initially created randomly. The algorithm will then:

1. Assign a fitness measure to each individual.
2. Select a number of high-fitness individuals as parents.
3. Produce new individuals (offspring) from the parents by means of evolutionary operators (e.g. crossover, mutation)
4. From the union of current population and offspring, select a number of individuals to survive into the next generation.
5. Go to (1) unless the individuals in the population fulfill some termination criterion.

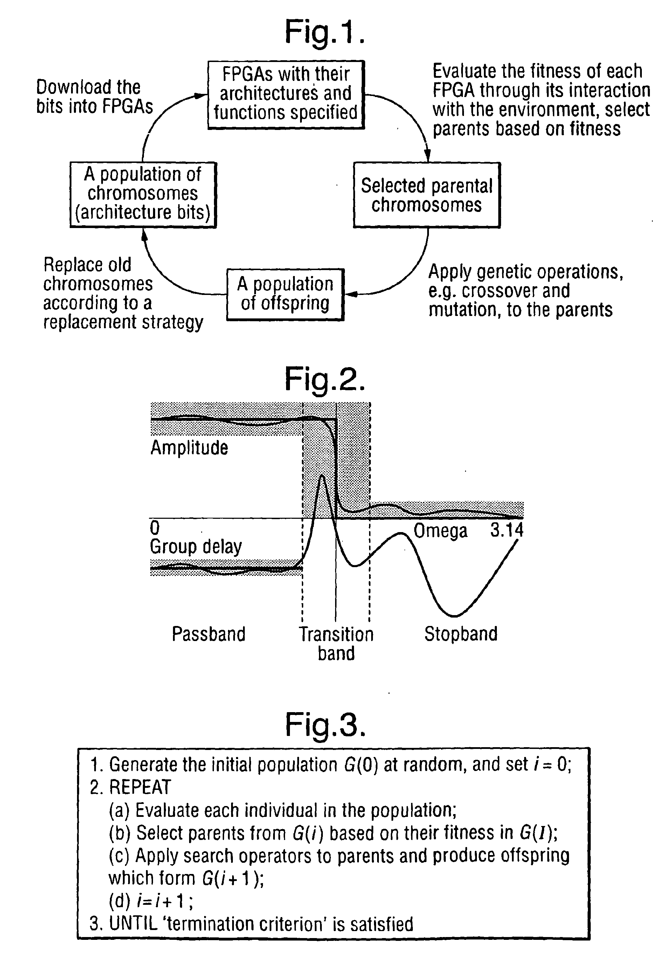

Figure 1 shows the major steps in an evolutionary cycle of EHW. An initial population of architecture bits encoded as chromosomes 10 are generated either at random or heuristically. They are then downloaded 12 into FPGAs 14 for fitness evaluation. In order to cut cost and save space, some EHW has only one set of FPGA hardware which will be used to evaluate fitness of every chromosome sequentially. The fitness of an FPGA, which is normally equivalent to the fitness of its chromosome, is evaluated through its interaction with the environment 16. Such fitness is then used to select parent chromosomes 18 for further reproduction and genetic operation. Crossover and mutation 20 are often used to generate offspring chromosomes 22 from the parents. These offspring will then replace their parents according to certain replacement strategy. Some replacement strategies may retain a parent and discard its offspring. A new generation of chromosomes are formed after replacement.

The schematic view of Figure 1 uses FPGAs as an example of EHW. However, the steps described are equally applicable to other types of EHW.

There are generally five levels of EHW that can be distinguished:

1. One-Shot Extrinsic: The generate-and-test cycle is completely done in software. Designs are tested in simulation, at the end of the process a design or a set of designs is created that can be implemented in hardware.

2. One-Shot Mixtrinsic: As level-1, but designs are evaluated both in simulation and on the actual hardware.

3. One-Shot Intrinsic: As level-1, but in each generate-and-test cycle, all designs are programmed into the hardware and evaluation takes place by testing the actual hardware. Control of the design process is done in software on a host computer.

4. One-Shot Intrinsic with On-Chip Control. As level-3, but part of the programmable hardware is used to implement the control of the design process.

5. Adaptive Intrinsic: As level-4, but the design cycle is repeated each time the environment changes, allowing the hardware to adapt to changing environments, hardware faults, etc.

From a research perspective, there is a large difference between level-1 and the rest. If the hardware is actually evaluated on the chip, the design can (and often will) incorporate effects that are not simulated, and usually not considered in conventional design process (e.g. parasitic coupling between cells). This can lead to very interesting, novel designs, but at the same time make analysis very difficult. Going from level-2 to level-5 is not trivial, but less of a research and more of an engineering/implementation problem. Of course, from a practical application perspective, level-5 could be very desirable.

All but level-1 EHW applications are based on reprogrammable hardware. Usually these are FPGAs and other PLDs; though analog reconfigurable devices are also used. Designs currently done using FPGAs or ASICs are most likely suitable. Evolutionary design is a generate-and-test approach. It is therefore a requirement that is possible to evaluate mechanically the circuits that are produced. Moreover, this test should be 'reasonably fast'. What exactly this means depends on a number of factors, especially the difficulty of the design (for some difficult problems, often millions or even a billion of circuit designs have to be evaluated), and the time available for the creation of a design.

EHW works best with designs with small to moderate complexity. In currently published applications, it seems that specifying and connecting about 30 elements is considered a difficult task. If the search space is restricted e.g. by limiting the possible interconnections, more elements can be used. What exactly an 'element' is depends on the implementation, it can be a single function cell on an FPGA (or transistor in an analog circuit); or a larger module, e.g. an arithmetic function unit.

A major strength of EHW is that it does not rely on established design methodologies (they can be used, but are not required). In fact, compared with other methods, evolutionary design methods generally are best used in areas where little design knowledge is available or where the available design methods restrict the set of circuits that can be designed. The more "black magic" or "trial and error" is involved in the design process, and the more likely it is that EHW will be able to produce better designs. Because of their population-based nature, evolutionary algorithms can often deal very well with multi-objective optimisation problems.

Level-5 EHW design is a special case. For applications where it would be desirable to have the hardware itself adapt to changing environments or re-wire itself to respond to hardware failures (fault-tolerant HW), EHW is considered a very promising approach. In this case, the EHW design process does not compete with a human designer, as there is no designer available for continuous re-configuration. Because of limited resources and fast response time requirements, small search space and fast testing are especially important in adaptive design applications.

A further article by Lee et al entitled "Digital filter design using genetic algorithm", Advances in Digital Filtering and Signal Processing, 1998 IEEE Symposium, 5-6 June 1998,,page 34 - 38 discusses digital filter design using genetic algorithms. The paper discusses an iterative method to design a digital filter and also examines the usefulness of various error and their impact on convergence rate and optimal result.

Another article by Zitzler et al, "Multiobjective evolutionary algorithm: a comparative case study and the strength Parento Approach" 1999, ffiEE Transactions on Evolutionary Computation, Nov 1999, Vol3, no 4 pages 257 - 271 discusses the various applications of EAs. A summary and quantitative comparison is also made of different EAs.

The invention aims to provide a method in accordance with claim 1.

Embodiments of the invention have the advantage that diversity of design is encouraged and maintained during the evolutionary process. This not only avoids premature convergence, but also ensures that unusual designs are considered that would not be considered by human expert designing the component.

Preferably, the steps of clustering comprises forming clusters on the basis or distance between genotypes. Preferably, reclustering is performed after a number n of generations of the process. This has the advantage that the clusters defined are distributed evenly over the chromosomes in the population.

Preferably, after a number of reclusterings the clusters are fixed so that there is no exchange of genetic material across clusters. This has the advantage of assisting in the maintenance of diversity.

Preferably, chromosomes are periodically removed from the Parento fronts of the clusters. This shifting of fronts has the advantage that it prevents fronts from growing too large and being populated with many similar individuals. Preferably the fronts are reduced by identifying pairs of non-dominated individuals having the smallest genotypic distance and removing the pair member having the worst fitness.

Preferably, tightening constraints are applied to the Pareto fronts. This has the advantage of removing extreme individuals from the front which could otherwise squeeze out promising individuals.

Preferably, the parent chromosomes are selected by one of four methods:-

selection using combined fitness, selection using shared fitness, and selection of non-dominated individuals over dominated individuals with niche count or cluster size being used where both individuals are non-dominated.

Preferably, the application of genetic operations to produce offspring includes mutation and/or crossover. Two-point crossover is preferably.

Embodiments of the invention may be used to design a wide range of hardware components, including digital filters. In the design of digital filters it is preferred that the chromosome genotypes are the pole-zero descriptions of the filters and the phenotypes are the transfer functions. This has the advantage that all linear IIR filters can be represented and that all phenotypes are feasible. Moreover, locality is preserved in that similar genotypes will have similar frequency responses and the search space is relatively smooth.

An embodiment of the present invention will now be described, by way of example only, and with reference to the accompanying drawings, in which:

Figure 1, is a schematic view of the major steps in an evolutionary cycle of evolvable hardware;
Figure 2, shows the amplitude and group delay of a possible low pass filter illustrating the constraints on the frequency response;
Figure 3, shows a framework of an evolutionary algorithm;
Figure 4, illustrates the different regions of a Pareto front;
Figure 5, shows the overswing of amplitude in the transition band of a low pass filter produced by a preliminary evolutionary system;
Figure 6, shows a graph of the best fitness in the population for the first and second runs;
Figure 7, shows a graph of the best fitness in the population for the fourth and fifth runs;
Figures 8 and 9 show, respectively, amplitude and group delay responses, for human designed filters for each of first and second problem cases together with a plot of poles and zeroes on the right hand side;
Figure 10 is a similar graph to figure 8 and 9, showing the best individual from best cluster of run 1 problem case 1;
Figure 11 is a similar graph to figure 8 and 9, showing the best individual from second best cluster of run 1 problem case 1;
Figure 12 is a similar graph to figure 8 and 9, showing the best individual from best cluster of run 2 problem case 1;
Figure 13 is a similar graph to figure 8 and 9, showing the best individual from best cluster of run 3 problem case 1;
Figure 14 is a similar graph to figure 10, showing the test individual from the best cluster in run 4 in problem case 2;
Figure 15 is a similar graph to figure 10, showing the test individual from the second best cluster in run 4 in problem case 2;
Figure 16 is a similar graph to figure 10, showing the test individual from the best cluster in run 5 in problem case 2;
Figure 17 shows a comparison of amplitudes between the human reference design and the evolved design from run 3; and
Figure 18 shows a comparison of delays between the human reference design and the evolved design from run 3.

The invention will be discussed in terms of the design of digital filters. It is important to stress that the invention resides in evolutionary computation techniques for hardware design. Digital filters are just one example of hardware that can be designed using the invention and the invention is not limited to digital filters or their design. The design approach to be described uses a vector based chromosome representation scheme with a number of crossover and mutation operators to manipulate the chromosomes. Different designs may be co-evolved using fitness sharing as will be described.

The design of digital filters using the method of the invention is attractive for a number of reasons:

The problem has engineering relevance. Digital filters play an important role in communication systems, often at the interface between digital and analog signal processing systems. Examples are mobile communications, speech processing, modems, etc.

Digital filters can be (and often are) implemented in reconfigurable hardware, and thus are suitable for EHW.

While the science of digital filter design is very well established and researched, there are no 'conventional' design procedures that lead to optimal designs with acceptable effort in the general case. Digital filter design is an active area of research.

The design space for digital filters is well defined but large and complex. A well defined space facilitates comparison of different results. A large and complex design space challenges the evolutionary system embodying the invention and will be good at evaluating our system's suitability in dealing with tough design problems.

A quantitative measure of filter performance is generally available, providing a fitness measure for EAs that is relatively easy to compute. It also provides a straightforward metric in comparing different designs.

There are many different kinds of digital filters, depending on types of components used (e.g., linear or non-linear components), restrictions on interconnections (e.g., with or without feedback) and the intended characteristics of the filter. The difficulty in designing individual filters depends on the exact type of filter; for some, analytical methods are available, for others approximation methods are used. In any case, different filters generally need different design approaches. A human designer specialised in designing one type of filter might not be able to design an optimal filter of a different type. Since no general design methodology is available, evolutionary design is a good and automatic alternative to manual design.

The embodiment to be described applies the method of the invention to a design problem described in a paper by W.S. Lu entitled "Design of Stable IIR filters with equiripple passbands and peak-constrained least-squares stop band", IEEE Transactions on Circuits and Systems II: Analos and Digital Signal Processing, vol 46, no. 11, pp. 1421-1426, 1999. In the paper, a conventional approach was held to solve two problems, producing two designs. The published results enable a direct comparison of the performance of designs created using conventional methods and evolutionary methods embodying the invention.

To assist understanding, some basic ideas and concepts of filter design will be described. While filter design techniques will be known to those skilled in that art, more detail can be found in filter design textbooks such as 'Digital Filters - Analysis, Design and Applications' by A. Antonion, McGraw Hill International, 2ed. 1993; and 'Digital Filter Design. Topics in Digital Signal Processing' by T.W. Parks and C.S. Burrus, John Wiley and Sons, 1987.

The embodiment described considers the design of a linear, infinite impulse response (IIR) digital filter. For linear filters, the behaviour can be characterised by the 'frequency response'. This is the phase and the magnitude of the output signal relative to the input signal, for all the frequencies between 0 and half the sampling frequency. This is generally expressed in terms of $\omega$, with $o \le \omega \le \omega_s/2$, where $\omega_s$ is the sampling frequency. The required behaviour of the filter is specified in terms of the frequency response.

In general, digital filter design is usually a two-step process. In the first step, a mathematical description of the filter fulfilling the design criteria is derived. This description is then transformed into a hardware description in the second step. The two steps are very different in terms of difficulty, methods employed, and performance criteria. Similar to most filter design papers the description only considers the more difficult first step. It produces an optimal (near optimal) polynomial that can then be transformed into hardware implementation.

Any linear digital filter can be mathematically specified by a complex-numbered polynomial function, i.e., the transfer function (Equation 1). This polynomial function, i.e., Equation 2, can be rewritten as the quotient of two product terms with the numerator specifying the zeroes of the polynomial and the denominator specifying the poles. The function usually has a scaling constant (Equation 2). The two descriptions are equivalent. It is easy to transform a pole-zero description to a polynomial description, but not vice versa. The frequency response can be derived from the transfer function by calculating the values for $z = e^{jwT}$ with T the sampling frequency.

$$H(z) = \frac{\sum_{i=0}^{n} b_i z^{n-i}}{z(n-r)\sum_{i=0}^{r} b_i z^{r-i}} . \qquad \text{EQU. (1)}$$

$$H(z) = b_0 * \frac{(z - z_{z0})(z - z_{z1})...(z - z_{zn})}{z^{r-i}(z - z_{p0})(z - z_{p1})...(z - z_{pi})} . \qquad \text{EQU. (2)}$$

Not all transfer functions can be realized in a hardware filter. Two main requirements have to be observed:

Real coefficents: The coefficients in the polynomial description directly translate to multipliers in the hardware implementation. Since it is very difficult to multiply a signal with a complex number, it is important that all coefficients are real. In terms of poles and zeroes, this can be achieved if all poles and zeroes are either real, or exist in conjugate-complex pairs (i.e. a + $jb$ and a - $jb$).

Stability: Because a general IIR filter has feedback loops, it may oscillate. The output may grow without bounds (or in hardware until overflow). In a stable filter, a bounded input will always produce a bounded output. A filter is only stable if all poles are within the unit circle, i.e. $\|a + jb\| < 1$. While there are uses for unstable filters in specific applications, most filters are designed to be stable.

Filter performance is usually multi-objective. There is not any universal criterion that applies to all filters. The precise objectives depend on the type of filters and engineering constraints imposed by their applications. The two example filters considered are low-pass filters. An application example would be a filter in a telephone system with a corner frequency of 20KHz. Signals with a frequency below this frequency should pass the filter unmodified, while signals above should be suppressed. An ideal low-pass filter lets signals pass unchanged in the lower frequency region (passband), and blocks signals completely in the upper frequency region (stopband). In reality, a transition band is often located between passband and stopband. The goal of filter design is to minimize distortion of the signal in the passband and maximize suppression in the stopband. The transition band should be as narrow as possible.

To minimise distortion in the signal in the passband, two criteria have to be met. The first is that the amplitude of the frequency response in the passband should be as constant as possible. For example, all frequencies in a speech signal should be amplified by exactly the same amount.

The second criterion is that the phase in the passband has to be as linear as possible. In practice, the so-called 'group delay', i.e., the first derivative of the phase $\delta\varphi/\delta\omega$, is often used. The second criterion can therefore be stated as a constant group delay. This means that all frequencies are delayed by the filter by the same amount of time. If the group delay is not constants, some frequencies pass the filter faster than others, leading to signal distortion at the output.

In the stopband, the design goal is generally to attenuate the signal as much as possible. Because the signal is attenuated, the phase and group delay of the signal in the stopband usually becomes unimportant.

For the transition band, constraints are rarely used.

Figure 2 shows a typical lowpass filter. The top half shows the amplitude and the lower half the group delay. The ideal behaviour 24 is shown with thick lines, the 'real' behaviour (thin line) 26 is acceptable as long as it is within the shaded regions.

To facilitate comparison between filters designed using methods embodying the present invention and other existing work, this report follows the criteria used in the W.S. Lu article referred to previously whenever possible, that is:

1. weighted square error over the amplitude in the passband and stopband,
2. peak amplitude in the stopband,
3. maximum deviation from constant amplitude in the passband,
4. maximum deviation from the goal group delay, and
5. the stability.

The conventional design process adopted by human experts uses criterion (1) as optimisation criterion and criteria (2) to (5) with predefined values as constraints. To examine whether our evolutionary system can discover a better design than a human design, criteria (2) to (5) are also imposed as constraints in our evolutionary system. In particular, stability is ensured by a linear inequality that implements a sufficient condition for stability in our chromosome representation. The detailed description of how the fitness function is implemented in the evolutionary system embodying the invention will be discussed in due course.

The Evolutionary Approach to Filter Design

Evolutionary Algorithms (EAs) refer to a class of population-based stochastic search algorithms that are developed from ideas and principles of natural evolution. They include evolution strategies (ES), [as described in H-P Schwefal, Evolution and Optimum Seeking, New York, John Wiley & Sons 1995], evolutionary programming (EP), [as described in D.B. Fogel, Evolutionary Computation: Towards a new Philosophy of machine intelligence: New York, NY: IEEE Press 1995], and genetic algorithms (GAs), [as discussed in D.E. Goldberg Genetic Algorithms in Search, Optimization and Machine learning. Reading, MA: Addison-Wesley, 1989]. One important feature of all these algorithms is their population-based search strategy. Individuals in a population compete and exchange information with each other in order to perform certain tasks. A general framework of EAs can be described by Figure 3.

It has been shown that EAs are particularly useful for dealing with large complex problems which generate many local optima. They are less likely to be trapped in local minima than traditional gradient-based search algorithms. They do not depend on gradient information and thus are quite suitable for problems where such information is unavailable or very costly to obtain or estimate. They can even deal with problems where no explicit and/or exact objective function is available. These features make them much more robust than many other search algorithms.

Chromosome Representation

The choice of (chromosome) representation for each individual is crucial in the success of any EA. Not only does it define the search space (in conjunction with the search operators), but it can also introduce biases into an evolutionary design process. If we have rich prior knowledge about a problem, we can use such knowledge to derive certain biases that make search more efficient. However, an incorrect bias will lead evolutionary search towards a wrong direction. We should minimise any strong biases that might be introduced by a representation. The representation therefore should fulfil a number of conditions. In this embodiment, an additional consideration exists: the presentation must facilitate the discovery of novel designs and design genes.

The representation used in an EA has to be 'appropriate' to the application domain. More specifically, a good representation should take the following into account.

Completeness: the representation should be able to represent all potentially interesting designs.

Feasibility: all genotypes under such a representation can be transformed into feasible phenotypes.

Locality: similar genotypes should produce similar phenotypes.

Smoothness: small changes in a genotype should produce small changes in its fitness.

This section, discusses how to represent a transfer function that defines a filter in a chromosome (i.e., a genotype).

As described, the transfer function is generally give in one of two forms: a polynomial or a pole-zero description of the filter. Because of the direct relationship between the transfer function and frequency response, poles and zeroes in the pole-zero form of the transfer function (Equation 2) can be directly interpreted: a pole near the current frequency amplifies the signal, a zero attenuates it. Since poles and zeroes are complex numbers, their locations in the complex plane can be naturally expressed in polar coordinates. Under such coordinates, the angle directly specifies the frequency at which the pole or zero is active, and the distance from the origin indicates its 'strength'.

As an alternative to this, it is also possible to directly encode the complex parameters of the polynomial (Equation 1) into genotypes. However, the parameters do not have any 'obvious' relation to the frequency response under such a representation. It is generally impossible to say how a change in a parameter will change the frequency response. Moreover, with direct encoding of complex parameters, it is impossible to directly test for stability while it is possible using the polar coordinates.

A polar coordinate based representation of poles and zeroes has the following advantages.

It can represent all linear IIR filters;
It is possible, as is shown below to ensure feasibility of all phenotypes;
Locality is preserved: that is, similar genotypes will have similar frequency responses; and

The search space is relatively smooth since changes in a genotype will cause small changes in the frequency response and therefore in the fitness of the genotype in most cases.

The transfer function of a filter can be represented by a sequence of paired real-value numbers, where each pair indicates the polar coordinates of a pole or zero. An additional pair of real-valued numbers encode the scaling parameter $b_0$. Each pair of real-valued numbers is called a gene.

In order to impose the constraints specified, poles and zeroes need to be either positioned on the real axis (i.e. $IM(z) = 0$), or exist in conjugate-complex pairs when a genotype is mapped to a phenotype (i.e., a transfer function). All poles have to be located within a unit circle in order to ensure filter stability.

For example, a genotype of $N_{p2} + N_{p1} + N_{z2} + N_{z1} + 1$ pairs of real-valued numbers consists of

$Np_2$ pole pairs: Each pair of real valued numbers in the genotype represents a complex pole. The conjugate complex pole is automatically generated by the genotype-phenotype mapping to ensure the filter is feasible. The radius can lie between -1.0 and 1.0, which ensures stability.

$N_{p1}$ single poles: For these poles, the angle is ignored. Only the radius is used to determine the position on the real axis. Radius is restricted to between -1.0 and 1.0.

$N_{z2}$ zero pairs: determines one of conjugate-complex pair of zeroes, the partner is automatically generated. The radius can lie between -1.0 and 1.0, but is scaled in the genotype-phenotype mapping with the factor $R_zM_{ax}$.

$N_{z1}$ single *zeroes:* The angle is ignored. The radius is between -1.0 and 1.0 and scaled with $R_zM_{ax}$.

Scaling factor $b_0$: The angle is ignored. The radius is used to scale the polynomial and is between -1.0 and 1.0 and scaled with $S_{Max}$.

Additionally, the transfer function can have $N(p0)$ poles in the origin. Table 1 below shows an example of genotypes with two conjugate-complex zero pairs, a single real zero, a single conjugate-complex pole pair, and a single real pole. It has two additional poles at the origin. If a zero scale $R_2M_{ax}$ of 2.0 and an overall scale of $S_{max} = 3.0$ is assumed, the genotype would translate into the following phenotype (transfer function):

$$H(z) = 5.1 * \frac{(z - (0.65 + j1.67))(z - (0.65 - j1.67))(z - (-0.39 + j1.14))(z - (-0.39 - j1.14))(z - 0.4)}{z^2 * (z - (-0.40 + j0.57))(z - (-0.40 - j0.57))(z - 0.5)}.$$

| $N_{z2} = 2$ | | | | $N_{z1} = 1$ | | $N_{p2} = 1$ | | $N_{p1} = 1$ | | $b_0$ | |
|---|---|---|---|---|---|---|---|---|---|---|---|
| 1.2 | 0.9 | 1.9 | 0.6 | 0.5 | -0.4 | 4.1 | 0.7 | 2.0 | 0.5 | 1.7 | 0.3 |

The scaling employed for zeroes and $b_0$ means that all pairs of real value numbers have exactly the same range: between -1.0 and 1.0 for radius, and between -n and n for the angle. This often facilitates evolutionary search without special knowledge about the differences between zeroes, poles, and $b_0$. The scales $R_{max}$ and $S_{max}$ are fixed in the experiments. Setting them optimally requires some domain knowledge.

Search Operators

The design of evolutionary search operators is closely coupled with the chromosome representation. Because the genes are pairs of real-valued members, not just single numbers, new search operators, such as crossover and mutation, are needed. The use as both crossover and mutation operators for chromosome representations is known in the art.

Crossover Operator

As radius-angle pairs are closely coupled, it does not seem to make sense to allow crossover to separate them. Crossover points are therefore limited to be between these pairs. In other words, two parents can only be crossed over between genes, not within a gene. Both uniform and two-point crossover have been implemented, with the later used in most experiments. It is worth noting that the uniform and two-point crossover operators implemented are generalised version of their binary counterparts.

Mutation Operator

Because of different ranges allowed, angle mutation is performed differently from radius mutation. Cauchy mutation is used in both cases. The scaling factor η in the mutation operators is fixed, but different for angle and radius. When a radius is mutated, the mutation is 'reflected' from the edges of the search space (e.g., if a pole currently has a radius of 0.9, and the mutation is +0.3, it will end up being (1.0-0.2)=0.8). When angle is mutated its value is simply 'wrapped around' at ± n.
We have appreciated that there is a high correlation between the locations of all the poles and zeroes, making it less likely that mutating single poles or zeroes would lead to improved fitness. Mutating all values at the same time, on the other hand, seems to disturb the genotype too much. As a compromise, the following approach is used:

for each gene is a genotype, a random decision is made on whether this gene is to be mutated. The probability of mutation is set such that on average 2 or 3 genes are mutated per genotype.

Encouraging and Maintaining Diversity

When designing a digital filter of non-trivial complexity, the search space that the algorithm has to search is usually very large. The search space is highly correlated and has many large, deceptive, low-fitness local optima. A naive EA can easily converge prematurely onto a local optimum and have difficulties finding acceptable results.
To avoid premature convergence, it is important that population diversity is encouraged and maintained throughout evolution. Population diversity may be achieved using Pareto optimisation, fitness sharing and clustering.

Pareto Fitness

Filter performance is generally multi-objective. A selection scheme based on Pareto fitness is a natural choice for our EA. In Pareto selection, any number of criteria can be used. Only a partial order among individuals, based on dominance, needs to be established. One individual dominates another if its fitness is higher than the other's according to at least one criterion and as good as the other's according to the rest of criteria. A population will usually contain a number of non-dominated individuals, which are referred to as the 'Pareto front'. Among individuals in the Pareto front, it is not possible to say which one is better than the other.

Different individuals from different regions in the Pareto front can have very different genotypes. Since they are non-dominated they should not directly compete with each other. Pareto fitness (and selection), while allow optimisation for different criteria, enables our EA to explore different regions in the search space. Such a method can maintain different high-fitness designs in the same population.

Fitness Sharing

While Pareto optimisation allows for exploration of different regions in the search space, it does not introduce any selection pressure into the EA to increase diversity. Most Pareto optimisation schemes, therefore, implement niching or fitness sharing. Fitness sharing refers to techniques that are used to modify the raw fitness of an individual such that 'similar' individuals will share fitness, i.e., have their fitness values reduced where the similarity measure is a key issue in fitness sharing techniques. The similarity of two individuals is defined here by the genotypical distance between them.

As shown by previous studies fitness sharing can increase and maintain population diversity and encourage the discovery of different individuals in the evolution. We have found that fitness sharing contributes greatly top increasing and maintaining population diversity in our evolutionary design system.

Similarity Measure Genotypes consist of pairs of real numbers. Each pair describes a point in the complex plane. The Euclidean distance between matching points of two genotypes can therefore be used as a measure of distance between them. Special care has to be taken for those pairs where the angle is ignored (single poles, single zeroes, and the overall scale). A constant angle is used in such cases. Points are matched solely on the position in the genotype. Poles and zeroes are not sorted. If two individuals happen to have the same poles or zeroes, but in different orders within the genotypes, they will have a large distance between them. The distance is accumulated over all pairs and give the total distance between two genotypes.

The distance calculation is done in Cartesian coordinates. To reduce conversion time in fitness sharing, each genotype caches the Cartesian equivalent of the polar coordinates.

Apart from the fitness sharing, the distance calculation is also required for clustering as will be described. Shared Fitness. Fitness sharing modifies the raw fitness of an individual according to the number of other individuals in the population which occupy the same 'niche'. Since distance calculation is computationally expensive, each individual is only compared to a small random sample of individuals in the population. This is somewhat similar to implicit fitness sharing. If the distance between two individuals as calculated above is below a threshold distance (i.e., the niche radius), the 'niche count' of the individual is increased by a value inverse proportional to the distance. The niche count is normalised by dividing it by the number of samples this individual has been compared with.

In the present sharing algorithm, only the overall combined fitness is subject to sharing. Because fitness has been defined such that lower fitness is better, fitness sharing needs to increase the fitness value for individuals with non-zero niche counts. The shared fitness is calculated as fitness* $(1.0 + \text{nicheCount}* c_8)$, where $C_8$ is a parameter that adjusts the degree of sharing. There are other parameters in our algorithm, e.g., the niche radius and the number of samples drawn from the population.

To allow for a greater flexibility, the combined fitness, shared fitness, and normalised niche count are all made available to selection.

Per-cluster Self-Adaptive Sharing. An important parameter in fitness sharing is the share (niche) radius. If it is too large, too many individuals will fall within the radius, and there will be little difference between the share value of individuals. It the radius is too small, only a few individuals will have any other individuals within the niche radius: again little information about niche sizes is gained. During the run of the clustering evolutionary algorithm, the distribution of individuals changes drastically, from individuals equally distributed over the search space at the initial population to individuals concentrated onto a few clusters later on. Furthermore, different clusters will have different distributions depending on the shape of the fitness landscape:

in some fitness peaks, individuals are much tighter together than on other peaks. For this reason, according to a preferred embodiment of the present invention, the niche radius is not fixed, but calculated on a per-cluster basis depending on the current population distribution. In each generation, after a sharing calculation using the current radius for that particular cluster, a new radius for the cluster is calculated as preferably 0.5 times the current average genotype distance of the individuals in that cluster.

Clustering

Pareto selection allows individuals at the Pareto front to co-exist as long as they are non-dominated. Fitness sharing can help increase and maintain population diversity. These two techniques are not very good at helping dominated individuals to survive in a population.

In order to search for different regions of a large design space and discover different high quality solutions, non-dominated individuals are preferred in most selection schemes and often make up a large portion of the population. Once a Pareto front is established, it will dominate any further search.

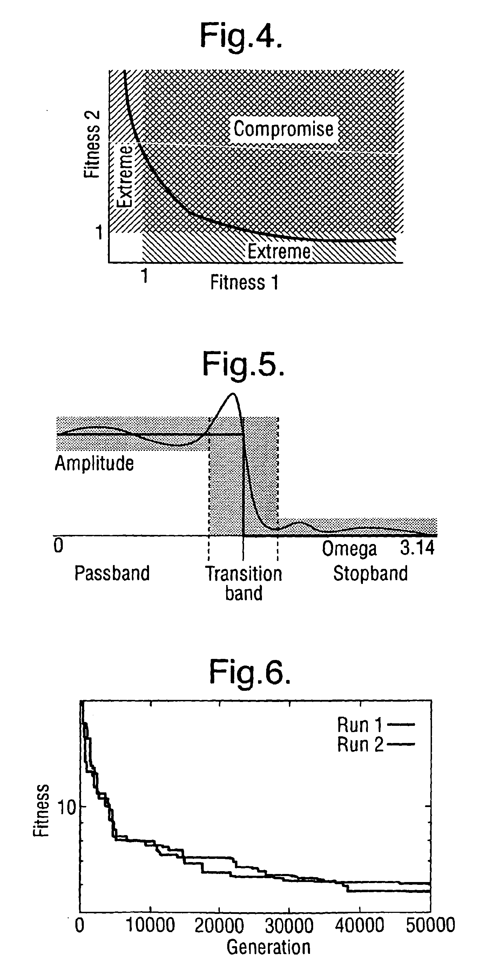

A Pareto front may have 'extreme' regions in which the fitness according to at least one objective is extremely good, but very poor according to other objectives. It may also have some 'compromise' regions in which the fitness according to different objectives in neither very good nor very poor. Figure 4 illustrates such two situations when two objectives are considered. In the figure, extreme regions are those in which fitness *1* or *fitness* 2 is lower than 1. The compromise region is the rest of the space. It is clear that we are not interested in any extreme regions because the fitness according to one of the objectives is too poor to be acceptable. There are a large number of potential solutions that are worth pursuing further in the compromise region.

When Pareto selection and fitness sharing were used in our evolutionary system, individuals in a population tended to be small variations of the same pole-zero configuration. Pareto selection and fitness sharing alone are not sufficient in generating drastically different designs. This is implemented using a two-stage clustering algorithm. In the first phase, the algorithm searches a large space, and the intention is to discover as many 'good' clusters as possible. For each cluster, a separate Pareto front is maintained, thereby ensuring that no single cluster can dominate the Pareto front. In the second phase, the algorithm searches all clusters more or less independently, no genetic material is exchanged among the clusters.

Pareto selection, fitness sharing produces interesting and promising results. Good solutions can often be found very quickly by one or two clusters which will maintain their superiority in terms of the best 'combined fitness' for a long time. However, better solutions will eventually emerge from other clusters when the one or two clusters approach their limits and stop improving. Clustering not only helps to increase and maintain population diversity, it also helps to find better solutions.

One disadvantage of using Pareto selection, fitness sharing and clustering is the extra computation time introduced. Although the time may be well spent in order to get better and novel design solutions, although the time may well be much shorter than the time used by a human designer to come up with the same design, it is nevertheless desirable to reduce the computation time as much as possible. The use of adaptive constraints, to be described, can reduce the computation time significantly.

Fitness Evaluation

Fitness evaluation is a challenging issue in design, because a design task is usually multi-objective and because it is sometimes difficult to quantify the quality of a design. Fitness evaluation is done in three steps. First, the genotype is converted into a phenotype according to the mapping described earlier. This phenotype is the transfer function of the filter. Second, the frequency response is derived by sampling the transfer function at regular intervals. A number of fitness values (according to different objectives) are computed from the frequency response. Third, fitness sharing is peformed.

Generating the Frequency Response

The transfer function is essentially a quotient of two products. Each product involves a number of terms in the form of $(z\text{-}z_{pn})$ or $(z\text{-}z_{zn})$, where $z_{pn}$ and $z_{zn}$ are the poles and zeroes derived from the genotype (see Equation 2). The filter response for a single frequency can be calculated easily by computing $z - e^{jw}$, the sums, the products and finally the quotient. Repeating the computation for $0 \le \omega \le 2\pi$ provides the frequency response.

All computation involve complex numbers. For a non-trivial filter with a large number of terms, considerable computational effort is required to compute the frequency response. A small saving in computation time can be achieved if by taking into account that poles and zeroes either are on the real axis or exist in conjugate-complex pairs. The computational effort depends directly on the number of samples used in our computation. In practice, it sometimes makes sense to use different sampling rates for passband and stopband. The number and placement of samples have different impacts on different objectives in design. Some objectives (i.e., fitness values according to those objectives) are rather sensitive to the number and placement of samples, while others are not. This sensitivity issue is not specific to the evolutionary approach. It equally occurs with any other approaches to filter design, including design by human expert.

Fitness values are calculated separately for each band.

Passband and Transition Band The human expert does not ordinarily impose any restrictions on filter's performance in the transition band. However, we found that a large 'overswing' in the amplitude in the transition band often occurs as illustrated in Figure 5. In other words, a signal very close to the cutoff frequency would be strongly amplified. This could lead to distortion in the signal. The transition band was therefore included in some of the fitness values for the passband in our system, i.e., in items (1) and (3) below.

Four values are calculated in fitness evaluation in the passband and transition band.

Thus, the criteria for the passband and transition band are as follows:

1. The maximum deviation (in dB) from amplitude 1.0 over the passband and over the transition band in areas where the signal is larger than 1.0.

2. The sum of, over all samples where the amplitude is outside the allowed band,

$$\left(\frac{amplitude}{MaxAllowedAmplitude}\right)^4 - 1$$

if the signal is larger than 1.0, including the transition band

$$\left(\frac{MinAllowedAmplitude}{amplitude}\right)^4 - 1$$

if the signal is less than 1.0, excluding the transition band.

3. The accumulated quadratic error, i.e., $\Sigma$ (amplitude - 1.0)$^2$, over the passband only.

4. The maximum deviation in the group delay from the goal group delay.

5. The sum, over all samples where the group delay is outside the allowed band, of $(delay\text{-}maxAllowedDelay)^8$ -1 or $(minAllowedDelay\text{ -}delay)^8$ -1).

Stopband In the stopband, the phase of the signal is ignored. Three values are calculated for the amplitude: The criteria for the stopband are as follows:

6. The maximum amplitude over the passband, inverted and converted into dB as follows:

$$1/(-20* \log_{10} (\texttt{maxAmplitude}))$$

If maxAmplitude <0.99

$11.455*20*(1+\log_{10} (\text{maxAmplitude}/0.99))$

Otherwise

The second form is required to produce a useful result for filters that do not actually implement any low pass behaviour, but have amplitudes larger than 1.0 in the stopband.

7. The sum, over all samples where the amplitude is above the allowed band, of $(amplitude/maxAllowedAmplitude)^4$ -1.

8. The accumulated square of the amplitude over the stopband.

In all cases (1 to 8), smaller values are always better. The system is implemented to minimise "fitness". Cases 1 to 8 provide a set of 8 criteria for design of the filter as a whole.

Combined Fitness For a multi-objective optimisation problem, there is seldom a single best individual that is better than all other individuals according to all objectives. In other words, there is no single objective (to be more precise, its fitness value) that can guide the evolution towards the right direction throughout the evolutionary search. We need to take all objectives into account. In our work, we have adopted a combined fitness value, computed as a weighted sum of different fitness values. In most of our experiments, the combined fitness function is a weighted sum of items (1), (4) and (6) above. The weights used are 10, 10 and 100, respectively.

Parent Selection

Parent selection has a large influence on the performance of EAs. Most of our experiments have been carried out using one of the following four methods:

1. Tournament selection using the combined fitness;
2. Tournament selection using the shared fitness;
3. Tournament selection with dominance using the niche count: if one individual is non-dominated, but not the other, the non-dominated individual wins the tournament. Otherwise, the individual with the smallest niche count wins;
4. Tournament selection with dominance using the cluster size: as above, but instead of niche count, the number of individuals in the same cluster is used.

At present, it is believed that 2 above provides the best tradeoff between the quality of the best individual in a population and the diversity in the population.

Replacement Strategy

Replacement strategy is used to selection individuals from the pool of all parents and offspring to survive to the next generation. This is different from parent selection described above. We have implemented a number of replacement strategies in our evolutionary system. A cluster based replacement strategy has been found to be very effective.
The clustering replacement strategy consists of four steps. In the first step, individuals are assigned to one of the clusters. Non-dominated individuals are identified. In the next two steps, a decision will be made on which of these non-dominated individuals will survive to the next generation. Finally, any remaining places in the next generation will be filled up from the remaining individuals in the pool of all parents and offspring.

Clustering and Identification of Pareto Fronts

Recent research has demonstrated the advantage of elitism in Pareto optimisation. In elitist Pareto optimisation, members of the Pareto front will be moved into an external 'store' and will not have to compete with other individuals for survival. We have implemented a simplified version of this. Members of the Pareto front remain part of the population in our case, but will be marked as non-dominated. As a consequence, most of them will automatically survive into the next generation.
Because of clustering, more than one Pareto front exists in a population in our evolutionary system. The motivation behind clustering is to maintain multiple Pareto fronts so that they do not compete against each other.
The first step of our replacement strategy is to ensure that each individual is assigned to one of the clusters. The number of clusters is fixed over the whole run (however, some clusters may be empty). Each single run of the algorithm has three phases, in which clustering is performed in a different way.
Initial phase: After the initial population is generated, it is clustered using the $k$-means clustering algorithm with the distance between genotypes computed as described. As a result of $k$-means clustering, a cluster-centre is established for each cluster.
Exploration phase: The aim of this phase is to identify a sufficient number of different clusters that have some chance of producing interesting results. In this phase, a population is reclustered at least every n generations (n = 100 for most of our experiments). Offspring that are created by crossover between parents from the same cluster or by mutation of a single parent will be assigned to the same cluster as the parent(s). Other offspring will be assigned to the cluster whose centre is closest to it. If the distance to the closest centre is more than m (m is around 1.8 for most of our experiments) times the largest distance between any two cluster centres in the population, a complete reclustering is triggered. This phase lasts a pre-set number of generations (e.g. 1000).
Exploitation phase: Reclustering and intra-cluster crossover can result in genetic material from one cluster 'contaminating' other clusters. If this material is very successful, it could eventually lead to all clusters converging. This does not help the discovery of different design solutions. Therefore, in the exploitation phase, all clusters are frozen. Crossover is only allowed between parents from the same cluster. No reclustering is performed. As a result, there is no interchange of genetic information among the clusters. All new offspring will inherit the cluster information from their parents. It is of course possible, and generally can be observed that within each cluster very different genotypes emerge. Such different genotypes are most likely to populate different areas of the cluster Pareto front.
After all offspring have been assigned to a cluster, the new Pareto fronts are computed. This is done on a per-cluster base. First, the non-dominated individuals in the offspring are computed. Then these are merged with the previous non-dominated individuals. Individuals are also checked against the current fitness constraints as described.

Shrinking Pareto Fronts

In most implementations of Pareto selection with elitism, the number of individuals in the Pareto front will grow continuously through the run. It is necessary to periodically remove individuals from the Pareto front to prevent the front and the population from overgrowing. Individuals are removed from the Pareto front of a cluster whenever the number of individuals in the front is above a pre-set threshold value.

Generally speaking, individuals should be removed whenever many very similar individuals can be found, because there is little incentive to keep very similar individuals. To achieve this, all individuals are 'paired': the two individuals which have the smallest genotypic distance are paired, then the two individuals with the next smallest distance are paired, etc. Each individual is allowed to be in only one such pair. Within each pair, one individual is removed. This process is repeated until sufficient number of individuals have been removed. The number of individuals to be removed is a pre-set parameter.

The decision about which individual of a pair to remove is based on the combined fitness of an individual. The better individual survives. The best individual in a population will never be removed from the population in the shrinking operation.

Tightening Constraints

Using Pareto selection, individuals with poor fitness values can still survive as long as they are not dominated by any other individuals. For example, the final population can easily contain 'filters' that do not allow any signal to pass, because they maximise the signal suppression in the stopband and are very different from other filters in the same population. These extreme individuals may make up a large fraction of the individuals in the Pareto front and squeeze out promising individuals in the compromise region of the front.

It is useful to have some kind of constraints for the individuals to restrict the number of such extreme individuals in a Pareto front. Unfortunately, setting these constraints is difficult. A harsh constraint will limit the number of extreme individuals, but it also runs the risk of excluding potentially good individuals. To get around this problem, a self-adaptive mechanism is used that adapts a constraint vector dynamically to the currently achieved fitness values in the population.

For every n generations, the constraints are tightened by a 'final constraints vector' (FCV). This vector has as many elements as there are fitness values. The values in it are pre-defined. They are the constraints that are applied at the end of a run. Typically, the current final constraints are set to be about 3-4 times the expected 'best individual' performance. A second vector, the 'current constraints vector' (CCV) is initialised with the worst possible fitness values (positive infinity in the case of minimisation).

For each particular fitness criterion, three different groups of individuals are distinguished:

the individuals with the best value for this particular fitness;
the individuals with the best overall combined fitness; and
the individuals with the worst value for this particular fitness.

When all fitness criteria are considered, individuals can be in more than one group. In particular, individuals in the first group for one fitness criterion are often also in the third group for a different fitness criterion. For example, individuals with the best signal attenuation in the stopband could have the largest amplitude deviation in the passband.

Generally speaking, the first group of individuals is often linked to the third group because those individuals are usually poor according to one or more other fitness criteria. The second group is important as it is most promising in producing solutions with useful compromises. To concentrate evolutionary search on individuals in the second group, the following algorithm is used.

1. Find the worst individual for each fitness criteria.
2. For each of the fitness criteria, calculate the quotient of the value in the FCV to the current worst value in the population. The criterion that has the largest quotient is selected for tightening.
3. Sort all non-dominated individuals according to the criterion selected in the previous step.
4. Identify the worst n individuals and mark them for deletion (n is a pre-defined parameter, e.g. 0.5% for a population of size 1400).
5. Update the CCV by setting the value for the selected criterion to that achieved by the worst remaining individual.

The CCV is used in deciding which individuals should be in a Pareto front. An individual whose one or more fitness values are worse than the values in the CCV will be allowed in the population, but not marked as non-dominated. It will not become part of the Pareto front. The values in the CCV will shrink each time the above algorithm is run. The speed of shrinking depends on the progress of the evolution. Once a value in the CCV reaches that in the FCV, it will not be reduced further.

It is possible that the individual with best combined fitness may be removed from the population. How likely this happens depends mainly on the number of individuals removed during each tightening. The speed of tightening is important. Fast tightening can improve the initial progress of evolution a lot, but may remove very promising individuals. Because promising individuals are generally compromises among different criteria. They are unlikely to be the best according to any single criterion and thus could be removed. In practice, it is sufficient to remove only a few individuals.

Another possible effect of constraint tightening is the removal of all individuals in a cluster especially when all individuals in that cluster have 'extreme' fitness values. When this happens, the algorithm will automatically increase the allowed size of the Pareto front of the remaining clusters. This is very useful because the algorithm can concentrate on the remaining clusters. In some sense, a limited degree of competition is introduced among clusters, poor clusters will be driven to extinction.

Dominated Individuals

After all the non-dominated individuals have been considered for the next generation, any vacant places in the next generation will be filled up by dominated individuals. To decide which individuals survive in the population, all dominated individuals in the pool of all parents and offspring are sorted by either the combined fitness, shared fitness, or niche count. The best of these individuals survive into the next generation.

Other Replacement Strategies

In addition to the replacement strategy described other strategies may be used. For runs without clustering, an elitist Pareto selection scheme can be used. This selection mechanism is a simplified version of that described above. Since it does not use clustering, only one Pareto front is maintained. The selection does not impose any constraints on the fitness values. Another strategy is a simple truncation strategy, where the best individuals survive into the next generation.

Figures 6 to 18 show the results of designs made using the evolutionary system described compared to those generated by the human expert in order to evaluate the quality of evolved filter designs.

In all the results discussed, 300 samples have been used in the passband and 200 in the stopband. To conduct a fair comparison, fitness values have been computed for the designs given by the human expert using exactly the same sampling and fitness computation methods as those in our evolutionary system. Because of sampling and rounding, the computed fitness values for the filters are similar to but not exactly the same as those reported by the human expert.

Two Test Problems

Both test problems are lowpass filters with slightly different numbers of poles and zeroes, cutoff frequencies, and goals for delays and amplitude.

Problem Case 1: $\omega_p$ = 0.2, $\omega_a$ =0.28, maximum amplitude deviation 0.1dB, minimum stopband attenuation 43dB, group delay = 11 samples with maximum deviation 0.35, order 15 with 7 zero pairs, 1 single zero, 2 pole pairs, 1 pole single, 10 poles at the origin.

Problem Case 2: $\omega_p$ = 0.25, $\omega_a$ = 0.3, maximum amplitude deviation 0.3dB, minimum stopband attenuation 32dB, group delay = 9 samples with maximum deviation 0.5, order 12 with 6 zero pairs, no single zeros, 5 pole pairs, 1 pole single, 1 poles at the origin.

Genotypes representing individuals require 12 pairs of numbers for case 1 and 13 pairs of numbers for case 2. When computing the fitness for the human design in case 1, it was noted that the amplitude curve seemed to be slightly too high. When the value for $b_0$ was modified from -0.00046047 as given in the W.S. Lu paper mentioned above, to - 0.000456475, the fitness value becomes very similar to that given in the paper. It is believed there is a typo or genuine mistake in that published paper. It might have been caused by rounding in the calculation of the frequency response. The corrected value is used in all the following performance comparisons.

Performance of the Evolutionary System

Table 2 below shows the results of three runs for design case 1. It lists the performance of the individual of a cluster with the best combined fitness, for all clusters used in run 1 and for the three best clusters in runs 2 and 3. Table 3 shows similar results for design case 2. The first row in the tables indicates the performance measures suggested by the human expert in the W.S. Lu paper to evaluate the quality of filters. In Table 2, PbmaxAmp is the passband maximum amplitude deviation (in dB), PbmaxDel is the passband maximum delay deviation (in samples), and SbmaxAmp is the inverse of maximum amplitude in the stopband (in dB) .

Several observations can be made immediately from Table 2. Firstly, three out of 20 clusters for run 1 are empty, indicating that the techniques described for tightening constraints and concentrating on more promising clusters appear to work.

Secondly, at least one better design that outperforms the filter designed by the human expert has been evolved in each run. According to the combined fitness that considers all design criteria, the best individuals in the 4th and 14th clusters in run 1 have achieved a performance of 6.085 and 6.046 respectively, which are better than 6.293 obtained by the human expert. The best individuals in the 4th cluster in run 2 and the 2nd cluster in run 3 have achieved 5.702 and 5.760, respectively, which represent 9.4% and 8.5% performance improvement over the human design. The best individual in the 19th cluster in run 3 also outperforms the human design although only marginally.

Thirdly, the evolved designs are quite different from each other as can be seen by close examination. For example, the best individual in the 4th cluster is run 2 has an extremely small maximum delay deviation in the passband (0.043) while the individual in the 2nd cluster in run 3 has a very small maximum amplitude deviation in the passband although both designs have similar combined fitness values. These two examples illustrate the power of the evolutionary system in discovering different designs. EAs can search a far larger design space than that examined by a human designer.

Fourthly, there is only one evolved design (the best individual in the 9th cluster in run 1) in Table 2 that achieved a better performance than the human design according to its stopband performance, although the combined fitness is worse. This appears to indicate that the stopband performance of 0.023 in the human design is quite hard to beat. At the same time, this also points out the direction for improving our evolutionary system, i.e., to increase the weight for *SbmaxAmp* such that more emphasis is put on this criterion in evolutionary search.

Table three shows the results for the second test problem. Table 3 shows similar points as those indicated by Table 2. Both runs 4 and 5 produce a better individual than the human design, the best individuals in the 15th cluster in run 4 and the 17th cluster in run 5.

In the experiments leading to the results of tables 2 and 3, runs 1, 2 and 4 used the combined fitness and three fitness values in column 3-5 in Tables 2 and 3. In runs 2 and 5, quadratic errors (i.e., criteria (3) and (8) in Section 3.5) were also used in deciding dominance and computing constraints. These values were calculated over the whole band and should provide more information about a design, since other values considered in fitness evaluation only gave information on a single point. Optimising square errors might also give the EA an additional 'pathway' to find better results.

Table 2

| Run | Cluster | PBmaxAmp | PBmaxDel | SBmaxAmp | combined |
|-----|---------|----------|----------|----------|----------|
| Human Design | | 0.103 | 0.293 | 0.023 | 6.293 |
| 1 | 1 | 0.310 | 0.186 | 0.041 | 9.043 |
| 1 | 2 | 0.199 | 0.418 | 0.029 | 9.090 |
| 1 | 3 | 0.098 | 0.412 | 0.032 | 8.391 |
| 1 | 4 | 0.217 | 0.057 | 0.033 | 6.085 |
| 1 | 5 | 0.248 | 0.247 | 0.032 | 8.120 |
| 1 | 6 | - | - | - | - |
| 1 | 7 | 0.253 | 0.506 | 0.026 | 10.221 |
| 1 | 8 | 0.354 | 0.188 | 0.0351 | 8.941 |
| 1 | 9 | 0.234 | 0.356 | 0.022 | 8.068 |
| 1 | 10 | - | - | - | - |
| 1 | 11 | 0.187 | 1.081 | 0.031 | 15.803 |
| 1 | 12 | 0.483 | 1.146 | 0.037 | 20.001 |
| 1 | 13 | 0.074 | 0.481 | 0.037 | 9.247 |
| 1 | 14 | 0.212 | 0.082 | 0.031 | 6.046 |
| 1 | 15 | 0.042 | 0.529 | 0.033 | 8.974 |
| 1 | 16 | 0.084 | 0.698 | 0.031 | 11.001 |
| 1 | 17 | 0.272 | 0.340 | 0.028 | 8.906 |
| 1 | 18 | - | - | - | - |
| 1 | 19 | 0.422 | 0.299 | 0.029 | 10.090 |
| 1 | 20 | 0.297 | 0.193 | 0.028 | 7.670 |
| 2 | 4 | 0.227 | 0.043 | 0.030 | 5.702 |
| 2 | 12 | 0.303 | 0.202 | 0.031 | 8.154 |
| 2 | 18 | 0.093 | 0.072 | 0.051 | 6.846 |
| 3 | 2 | 0.052 | 0.160 | 0.036 | 5.760 |

15

(continued)

| Run | Cluster | PBmaxAmp | PBmaxDel | SBmaxAmp | combined |
|-----|---------|----------|----------|----------|----------|
| 3 | 11 | 0.151 | 0.128 | 0.041 | 6.912 |
| 3 | 19 | 0.081 | 0.241 | 0.031 | 6.288 |

Table 3

| Run | Cluster | PBmaxAmp | PBmaxDel | SBmaxAmp | combined |
|-----|---------|----------|----------|----------|----------|
| Human Design | | 0.271 | 0.437 | 0.030 | 10.099 |
| 4 | 1 | 0.398 | 0.262 | 0.042 | 10.783 |
| 4 | 2 | 0.486 | 0.334 | 0.044 | 12.526 |
| 4 | 3 | 0.219 | 0.651 | 0.044 | 13.006 |
| 4 | 4 | 0.268 | 0.361 | 0.042 | 10.467 |
| 4 | 5 | 0.638 | 0.256 | 0.047 | 13.657 |
| 4 | 6 | 0.948 | 1.650 | 0.065 | 32.524 |
| 4 | 7 | 0.707 | 1.429 | 0.034 | 24.656 |
| 4 | 8 | 0.512 | 1.226 | 0.066 | 23.978 |
| 4 | 9 | 0.781 | 0.326 | 0.032 | 14.320 |
| 4 | 10 | 0.514 | 0.626 | 0.071 | 18.555 |
| 4 | 11 | 0.614 | 1.234 | 0.049 | 23.453 |
| 4 | 12 | 0.407 | 1.174 | 0.045 | 20.349 |
| 4 | 14 | 0.544 | 0.809 | 0.025 | 16.051 |
| 4 | 14 | 0.190 | 0.564 | 0.041 | 11.633 |
| 4 | 15 | 0.317 | 0.319 | 0.034 | 9.764 |
| 4 | 16 | 0.271 | 0.454 | 0.049 | 12.183 |
| 4 | 17 | 0.519 | 0.267 | 0.059 | 13.807 |
| 4 | 18 | 0.864 | 0.287 | 0.034 | 14.913 |
| 4 | 19 | 0.236 | 0.731 | 0.048 | 14.438 |
| 4 | 20 | 0.294 | 0.334 | 0.038 | 10.152 |
| 5 | 7 | 0.404 | 0.144 | 0.047 | 10.190 |
| 5 | 14 | 0.426 | 0.147 | 0.044 | 10.156 |
| 5 | 17 | 0.359 | 0.262 | 0.038 | 10.016 |

Runs 1, 2, 4 and 5 were run for 50,000 generations using a population size of 1400. A maximum of 70 individuals were allowed in the Pareto front in each cluster, and a minimum of 50 after shrinking the Pareto front. Run 3 used the same parameters, but was run over 67,000 generations. A run of 50,000 generations typically took up to 1.5 days on a 500MHz Pentium computer.

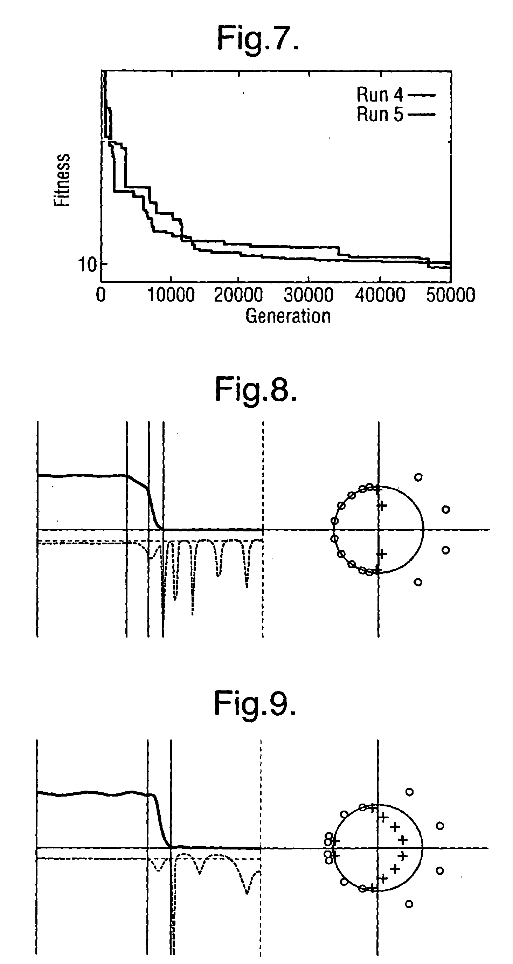

Figures 6 and 7 show the evolutionary process of the system. The curves in the figures indicate the best fitness in the population. The figures show that the fitness was still improving even around 50,000th generation. It seems very likely that better designs would have been found if we had run the experiments longer. It is worth pointing out that it is not always true that the longer the computation tim eth ebetter the solution will be. An EA can make progress in its search only when there is sufficient population diversity. Because of Pareto optimisation, fitness sharing and clustering implemented in our system, we can maintain the population diversity at a high level in the present evolutionary systems for a much longer time than other EAs. That is one of the primary reasons why better performance could be expected if the number of generations had been increased.

Examples of Evolved Design

For comparison purposes, Figures 8 and 9 show the two filters designed by the human expert. The left of each figure shows the response of the filter. The top curve is the amplitude. The lower curse indicates the group delay of the filter. The three vertical lines indicate ($\omega = \omega_p$, $\omega = 0.25$, $\omega = (\omega_a$. Both amplitude and delay curves use linear scales. On the right hand side of the figures, the poles and zeroes of the transfer function are shown. Poles are indicated by crosses and zeroes by circles.

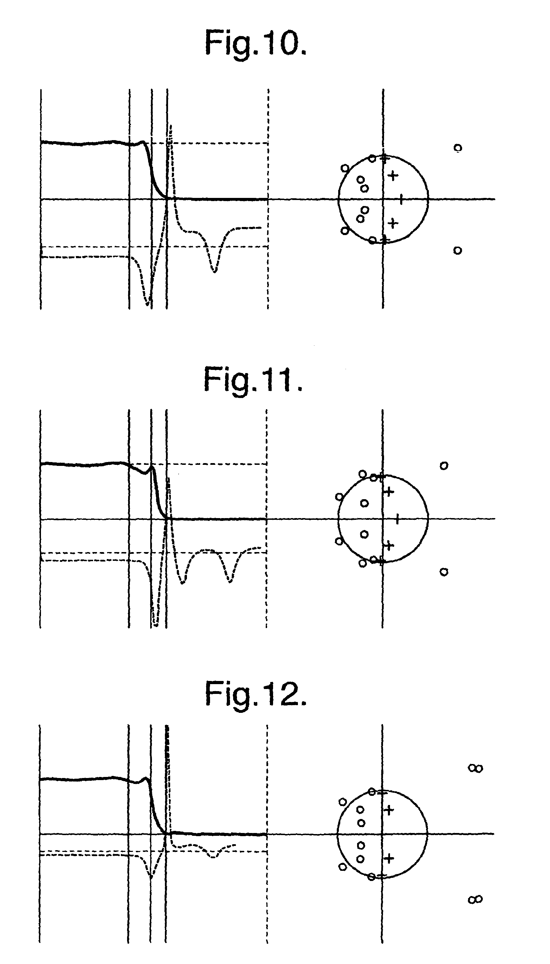

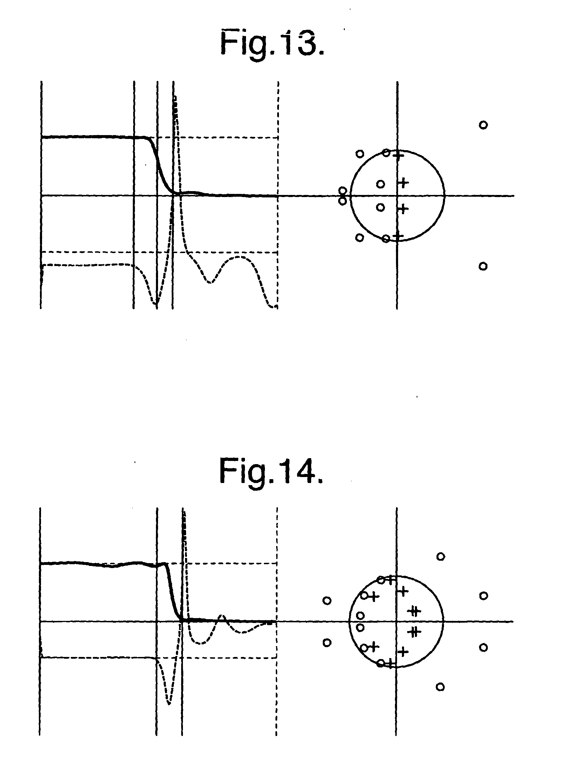

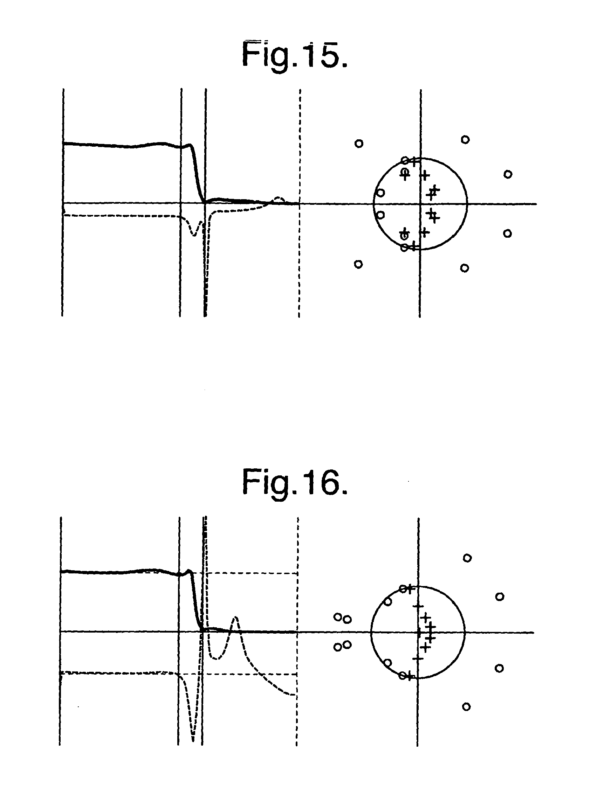

Figures 10 and 16 show the evolved filter designs. Figure 10 and 11 show the best individuals in the best (14) and second best (4) clusters in run 1. Figure 12 shows the best individual from the best (4) cluster in run 2 and figure 13 shows the best individual from the best cluster (2) in run 3. The pole-zero diagrams can be compared quite easily to examine the differences in design. For problem case 1, the evolved design from the 14th cluster in run 1 (Figure 10) and that from the 4th cluster in run 2 (Figure 12) have similar pole-zero diagrams. The pole-zero diagrams in Figure 11 (the best individual in the 4th cluster in run 1) and Figure 13 (the best individual from the 2nd cluster in run 3) are also similar to each other. However, they are all very different from the pole-zero diagram of the human design in Figure 8. They are certainly novel in the sense that a human designer would not usually come up with such designs.

The discovery of different designs is even more clearly illustrated by the evolved filters for problem case 2, where almost all evolved designs (Figures 14 to 16) are fairly different from each other and from the human design. Figures 14 and 15 show, respectively, the best individuals from the best and second best clusters in run 4. These are from clusters 14 and 20 respectively. Figure 16 shows the best individual from the best cluster, cluster 17, in the fifth run.

Comparison of Evolved and Human Designs

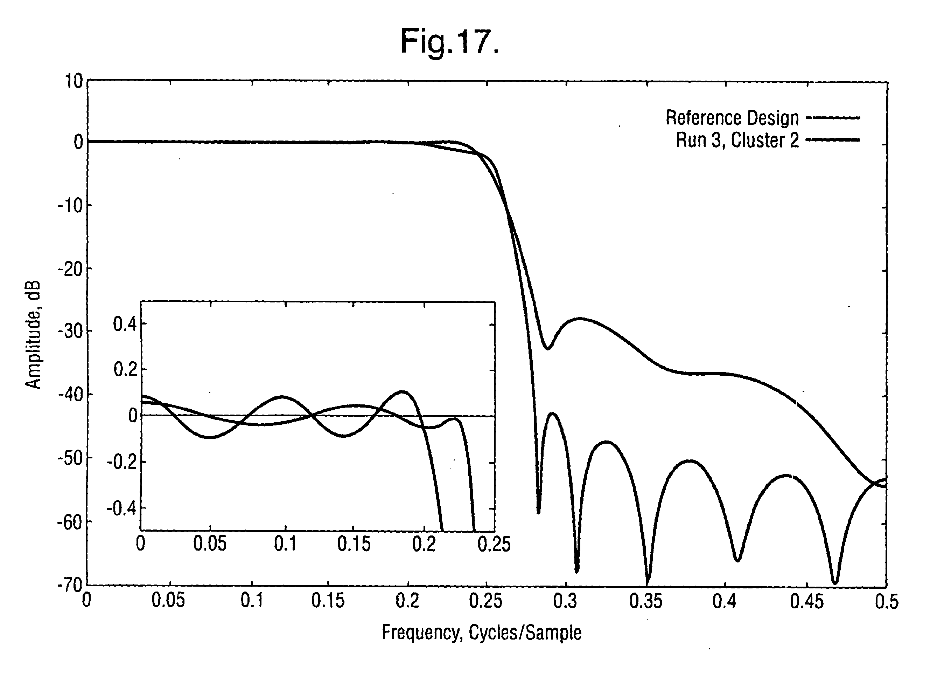

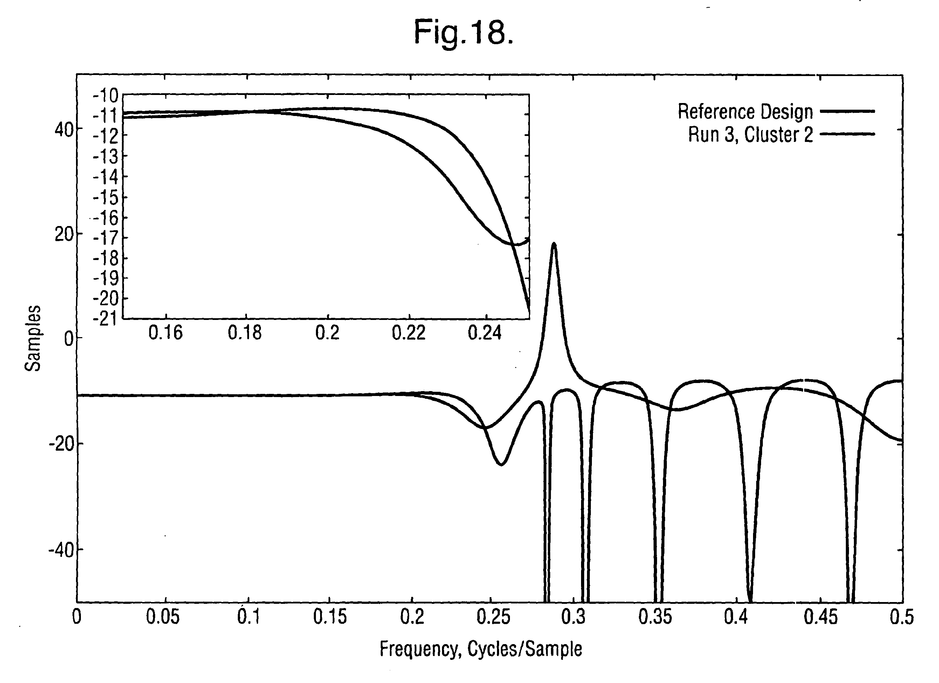

Figures 17 and 18 compare the best evolved design (run 3 cluster 2) and the human design, labelled as reference design in the figures, in detail for problem case 1. In Figure 17, the logarithmic scale for the amplitude emphasises the difference in the stopband performance. The evolved design is clearly better. As the inset shows, the passband performance is noticeably flatter (which is good).

Figure 18 shows clearly why the evolved filter design has a better performance in terms of delay. The performance is completely determined by the value right at the end of the passband. Because the evolved filter swings up at the end it has a considerably better fitness. This figure also explains why the sample frequency and positions are so important: the delay at this point has a very steep gradient, and any change in sample position will produce a strong change in the value.

Other Experiments

In addition to the above results, we have carried out some other experiments using different selection schemes and replacement strategies in order to evaluate the pros and cons of different techniques, including those developed by ourselves. For example, the 'replace worst' strategy mentioned above was used in a number of experiments. This strategy has a much stronger selection pressure against poor individuals and encourages fast convergence. As expected, it leads to shorter computation time but has the risk of converging to a less than satisfactory solution.

Rather than start evolutionary design from scratch every time when we have some fairly good human designs already we have appreciated that evolutionary calibration is beneficial, exploiting the knowledge in the human designs as much as possible. To achieve this, we initialised a small fraction (10%) of the initial population with individuals mutated from the human design. Such a small fraction of mutated human designs will introduce some potentially useful genes into the population without losing much population diversity. Our preliminary results have revealed that such initialisation could lead to up to 10% performance improvement over the human design in a very short time. A close analysis showed that such improvements were mostly fine adjustments because the evolved solutions tended to be similar to the human design. However, fine adjustment of some parameters lead to significant performance gain. Since many industrial products needs tuning and calibration before they are delivered, our experimental study shows that EAs can be a very promising calibration and fine-tuning tool for such tasks.

The embodiments described provides an evolutionary design system that emphasises the discovery of novel and unconventional designs. Digital filter design has been used as an example to illustrate how the evolutionary system evolves different filters using techniques such as Pareto optimisation, fitness sharing, clustering, etc. A number of techniques have been implemented and experimented with in our system. The experimental results give demonstrate that evolutionary computation techniques can be used effectively to evolve designs that are very different from those designed by human experts. The evolved designs often perform better than the human design. One of the primary reasons behind this success is EA's ability in exploring a much larger design space and, as a consequence, discovering designs that are overlooked by human designers.

One disadvantage of evolutionary design is its long computation time. However, although evolutionary design can be time-consuming, it relieves, at least partially, the human designer from trying and testing different design alternatives. The time taken by an evolutionary design system will often be less than that taken by a human designer in producing a good design.

Evolutionary computation techniques can be used as problem saving tools as well as discovery engines. The system evolves high quality designs. The discovery and extraction of good designers hidden in evolved designs may lead to new design principles or components which could be used in different design tasks without reverting to the evolutionary system every time.

Designing hardware using EAs is very different from conventional design. Evolutionary design is knowledge-lean and very explorative. It complements conventional design rather than competes against it. Conventional design refers to the existing approach followed by most designers. Conventional design usually employs a deterministic algorithm or procedure to derive a design from an established model. For example, quadratic programming was used in the filter design by the human expert.

It is relatively straightforward to formulate a design problem as a multi-objective optimisation problem in an evolutionary design system. Although the setup cost of an evolutionary design system is high because the system has to be developed, it is relatively cheap to run after the system is developed. For example, when different filters are needed, the evolutionary design system simply uses a different fitness evaluation function for each filter. However, an entirely different algorithm may have to be developed for a different filter in the conventional approach used by the human expert.

Table 4 summarises the major differences and similarities between conventional and evolutionary approaches to hardware design. Some of these comparisons are specific to the filter design problem and thus are illustrative.

Table 4

|  | Conventional Design | Evolutionary Design |
|---|---|---|
| Required domain knowledge | Much | Less |
| Explored design space | Small | Large |
| Novel designs in one run | Less likely | Likely |
| Time per design |  | slow |
| Search | Deterministic | Stochastic |
| Multi-Objective Design | No | Yes |
| Initial Setup Cost | Low | High (EA Software) |
| Effort per Problem Class | High (Research) | Low (Fitness) |

The manner in which objectives and constraints are determined can have a major impact on the design outcome. In the evolutionary approach, objectives and constraints are encoded directly in the fitness function and chromosomes (genotypes). The fitness function directly measures whatever objective is used, e.g., the maximum deviation from linear amplitude. Constraints can be either made part of the fitness function or encoded into chromosomes. For example, our chromosome representation guarantees that no unstable filters will be generated in evolution. As a result, no test for stability is necessary. This is achieved without sacrificing any feasible design space.

In the conventional approach to filter design, it is necessary to linearise the constraints which will actually excludes some stable designs. In other words, part of the feasible search space are excluded from being considered by the conventional approach. Furthermore, because an objective in the form of 'minimize maximum value' cannot easily be linearized, the optimisation is actually done using the weighted smallest quadratic error over the whole function. That is, what was optimised is not entirely the same as what should be optimised. The conventional algorithm might well miss good designs that have a larger weighted square error, but a lower maximum error.

The software used to implement the method embodying the invention described is developed in Java and built around a plug in architecture with a configuration file specifying which modules are loaded to perform operations. This allows different combinations of operators to be explored. Two different kinds of modules are used. The basic parts of the evolutionary algorithm are defined in terms of interfaces, with one or more modules being designed to implement each interface. The other set of modules implement only a basic hookable interface: these modules register for certain hooks on load. These allow meta-level operators to be introduced into the structure of the algorithm. There is some interdependency between modules, for example it is important that modules run the required hooks to activate the 'meta-level' modules. Modules are only implemented as they are required.

Java enables all module objects to be saved simply to file, so that all run data can be saved. However, in Java, this data cannot be reloaded once the objects have changed. Thus, adding a single method to a class would make it impossible to load saved run data. All modules, therefore, have to save their run data to file individually. This will still work when files changes provided that the data format does not change.

The basic modules are:

Loader This is not actually a module, but is the only fixed element. It handles loading all modules, running initialising hooks, and re-loading of saved data when a run has to be restarted. It allows for repeated runs to collect statistical data.

Loop implements the basic evolutionary algorithm loop, it calls the evolutionary and selection modules, and runs hooks at the beginning and end of each loop.

GenotypeFactory creates genotypes appropriate for the representation chosen.

Population implements the population store, it allows adding, removing and selecting individuals from the population. The currently used module implements a single population, but distributed models would be possible too.

ParentSelection is responsible for the selection of parents from the population.

Genetics takes the parents and returns a list of offspring, using the BinaryOperator and Unary Operator modules.

BinaryOperator implements one or more binary genetic operators, e.g. crossover
UnaryOperator implements unary genetic operators, typically mutation

Evaluation takes a list of individuals and evaluates them, currently all individuals are evaluated sequentially, but distributed evaluation would be possible.

FitnessFunction is used by evaluation to calculate the fitness of single individuals.

Replacement combines the current population and offspring into a new generation.

Termination returns 'true' if the run should be terminated.

Statistics Keeps basic statistics of loop count, population size, best and average fitness, etc.

The following modules implement meta-level functions. Which of the modules are loaded depends on the property file passed to the EA loader. The modules rely on appropriate hooks to be run from within the basic modules.

FitnessSharing Is run after each evaluation, and after each loop, and implements fitness sharing.

InjectSolutions Run after the initial individuals have been created, injects individuals that have been created from a known solution.

PrintStats Prints statistics on the screen.

SaveStats Saves statistics to file.

SaveRun Regularly runs the 'saveYourself' hook to instruct all modules to save their data to file.

ResponsePlotter Plots the best individual.

The description has been given in relation to a low pass digital filter. Digital filter design has a number of features that make it suitable for evolutionary approaches. Very often, filters can be created from a relatively small number of high-level elements with a limited set of interconnections; useful designs are therefore possible within a search spec that can be explored by an evolutionary algorithm. Also, it is relatively easy and fast to test a digital filter, either in simulation or in hardware.

Depending on the type of filter designed, very few conventional design methods may be available. The design of linear feedback-free filters (FIR filters) is generally straight-forward, but for filters with feedback (IIR filters), design methods only exist for specific types of filters. Non-linear filters are nearly impossible to treat analytically, and therefore very difficult to design.

Finally, in areas like mobile communications, changes in the channel characteristic would require adaptive designs. A filter based on evolutionary HW can possible adapt the structure to the filter to different environments 'on-the-fly'. With conventional design, the only adaptation possible is the change of coefficients in a filter circuit, generally a FIR filter.

By contrast, the design of a maths co-processor or similar kind of device is not very likely to be a good application domain, for a number of reasons. Generally, the designs are likely to be very large and complex, implying a very large search space to be search. Also, because of the number of inputs and internal states testing is very slow, if possible at all. Together, this makes the task very hard for an evolutionary approach.

On the other hand, a large body of knowledge is available on how to design the units, and adaptation of the hardware to new environments is generally not required. Conventional design methods therefore are likely to be more useful for such a design task.

It will be appreciated from the above that the method of the invention is suitable for designing many other types of hardware components. A non-exhaustive list includes high-order, analog filters, analog amplifiers, analog circuits, microwave image rejection mixers, analog filter calibrators, non-linear digital filters, digital equalisers, lossless digital image compression. This list is only included to give a few examples. Many others are possible and will occur to those skilled in the art.

**Claims**

1. A method of designing a digital filter using an evolutionary algorithms, comprising the steps of:

   a) providing an initial population of transfer functions of digital filters;

b) encoding each individual of the initial population as a chromosome;

c) evaluating the fitness of each digital filter represented in the population by converting the genes of the chromosome representing the digital filter into a phenotype and assessing the phenotype according to multi-objective fitness criteria imposed by engineering constraints of an intended application of the digital filter;

d) selecting parent chromosones based on the fitness evaluation of step (c) ;

e) applying genetic operations to the selected percent chromosomes to produce offspring chromosomes ;

f) selecting a set of chromosomes from the parent and offspring chromosomes to form chromosomes of a population of a new generation of chromosomes; comprising ;

- assigning each parent and offspring chromosomes to one of a plurality of clusters;
- forming a Pareto front of non-dominated chromosomes for each cluster; and
- applying tightening constraints comprising determining the worst chromosomes for each particular fitness criterion and eliminating said chromosomes from the Pareto fronts of the clusters;

g) repeating steps c) to f) independently for each cluster of each new generation of chromosomes predetermined criterion is satisfied.

2. A method according to claim 1, wherein the steps of clustering the parent and offspring chromosomes comprises forming clusters on the basis of the distance between genotypes.

3. A method according to claim 1 or 2, comprising performing a reclustering after a predetermined number, n, of generations.

4. A method according to claim 3, wherein in the step of reclustering, offspring having a single parent or two parents in the same cluster are reclustered into the parent cluster, and other offspring are assigned to the cluster having the closest centre.

5. A method according to claim 3 or 4, wherein during an exploitation phase no reclustering is performed over a number of generations.

6. A method according to claim 3, 4 or 5, comprising forming a new Pareto front for each cluster of the reclustered chromosomes.

7. A method according to any one of claims 1 to 6, wherein the number of clusters is fixed.

8. A method according to any one of claims 1 to 7, comprising removing chromosomes from a Pareto front when the number of hardware elements in the front exceeds a predetermined threshold.

9. A method according to claim 8, wherein the step of removing the chromosomescomprises paring chromosomes separated by the smallest genotypic distance and removing the chromosome from the pair that has the lower fitness.

10. A method according to claim 1, wherein the step of applying tightening constraints comprises:

for each fitness criteria, identifying the worst chromosome for that fitness criteria, determining a value of a pre-defined final constraints vector (FCV) that corresponds to that fitness criterion and calculating a quotient of the value of the FCV to the corresponding fitness value for the identified worst chromosome;

selecting the fitness criterion that has the largest quotient,

sorting all non-dominated chromosomes according to that fitness criterion,

identifying a pre-determined percentage of the worst chromosomes according to that criterion, and

eliminating the chromosomes of the identified hardware elements.

11. A method according to claim 10, comprising updating a current constraints vector (CCV) by setting a value corresponding to the selected fitness criterion to the corresponding fitness value for the worst chromosome remaining after eliminating the identified chromosomes and presenting chromosomes whose one or more fitness values are worse than the corresponding values in the CCV from being marked as non-dominated.

12. A method according to claim 11, wherein each value of the CCV is not reduced further once the value reaches the corresponding value of the FCV.

**13.** A method according to any one of claims 1 to 12, wherein the selection of parent chromosomes is based on the combined fitness of the chromosomes according to the fitness criteria.

**14.** A method according to claim 13, wherein combined fitness is a weighted sum of fitness criteria.

**15.** A method according to any of claims 1 to 12, wherein the selection of parent chromosomes is based on the shared fitness in which the fitness of a chromosome is defined by the number of other chromosomes occupying a fitness niche.

**16.** A method according to any of claims 1 to 12, wherein the selection of parent chromosomes is based on selection of non-dominated chromosomes and, where selection is between non-dominated chromosomes, the smallest niche count.

**17.** A method according to any of claims 1 to 12, wherein the selection of parent chromosomes is based on selection of non-dominated chromosomes and, where selection is between non-dominated chromosomes, the size of the cluster to which individuals belong.

**18.** A method according to any one of claims 1 to 17, wherein the application of genetic operations to the parent chromosomes comprises mutation of the chromosomes.

**19.** A method according to any one of claims 1 to 18, wherein the application of genetic operations to the parent chromosomes comprises cross-over of genes.

**20.** A method according to claim 19, wherein the cross-over comprises two-point cross-over.

**21.** A method of redesigning a digital filters according to any one of claims 1 to 20, wherein steps (a) and (b) comprise generating, from the existing hardware element, a population of offspring chromosomes, by applying genetic operations to a chromosome representation of the hardware element.

**22.** A method according to any one of claims 1 to 21, wherein the chromosomes have genotypes comprising a pole-zero, description of the filter.

**23.** A method according to claim 22, wherein the chromosome phenotype is the transfer function of the filter.

**24.** A computer program runing on a computer, causing the computer to perform the Method of any of claims 1 to 23.

**Patentansprüche**

**1.** Verfahren zum Entwerfen eines Digitalfilters unter Benutzung eines evolutionären Algorithmus, welches die folgenden Schritte umfasst:

a) Bereitstellen einer Anfangspopulation von Übertragungsfunktionen von Digitalfiltern;
b) Codieren jedes Individuums der Anfangspopulation als ein Chromosom;
c) Bewerten der Fitness jedes in der Population repräsentierten Digitalfilters durch Umwandeln der Gene des das Digitalfilter repräsentierenden Chromosoms in einen Phänotyp und Beurteilen des Phänotyps entsprechend multiobjektiven (mehrzieligen) Fitnesskriterien, die durch technische Restriktionen einer beabsichtigten Anwendung des Digitalfilters auferlegt werden;
d) Wählen von Elternchromosomen auf der Basis der Fitness-Bewertung von Schritt (c);
e) Anwenden genetischer Operationen auf die gewählten Elternchromosomen, um Nachkommenchromosomen zu erzeugen;
f) Wählen einer Menge von Chromosomen aus den Eltern- und Nachkommenchromosomen, um Chromosomen einer Population einer neuen Generation von Chromosomen zu bilden, umfassend:

- Zuweisen jedes Eltern- und Nachkommenchromosoms zu einem von mehreren Clustern;
- Bilden einer Pareto-Front von nicht dominierten Chromosomen für jedes Cluster; und
- Anwenden von verschärfenden Restriktionen, das Bestimmen der schlechtesten Chromosomen für jedes spezielle Fitnesskriterium und das Beseitigen dieser Chromosomen aus der Pareto-Front der Cluster umfassend; und

g) Wiederholen der Schritte c) bis f) unabhängig für jedes Cluster jeder neuen Generation von Chromosomen, bis ein vorgegebenes Kriterium erfüllt ist.

**2.** Verfahren nach Anspruch 1, wobei die Schritte der Clusterbildung aus den Eltern- und Nachkommenchromosomen das Bilden von Clustern auf der Basis des Abstands zwischen Genotypen umfassen.

**3.** Verfahren nach Anspruch 1 oder 2, welches das Durchführen eines Reclusterings (Umclusterung) nach einer vorgegebenen Anzahl n von Generationen umfasst.

**4.** Verfahren nach Anspruch 3, wobei in dem Schritt des Reclusterings Nachkommen mit einem einzelnen Elternteil oder zwei Elternteilen in demselben Cluster in das Elterncluster umgeclustert werden und andere Nachkommen dem Cluster mit dem nächsten Mittelpunkt zugewiesen werden.

**5.** Verfahren nach Anspruch 3 oder 4, wobei während einer Ausnutzungsphase über eine Anzahl von Generationen kein Reclustering durchgeführt wird.

**6.** Verfahren nach Anspruch 3, 4 oder 5, welches das Bilden einer neuen Pareto-Front für jedes Cluster der umgeclusterten Chromosomen umfasst.

**7.** Verfahren nach einem der Ansprüche 1 bis 6, wobei die Anzahl der Cluster fest ist.

**8.** Verfahren nach einem der Ansprüche 1 bis 7, welches das Entfernen von Chromosomen aus einer Pareto-Front umfasst, wenn die Anzahl der Hardwareelemente in der Front einen vorgegebenen Schwellenwert übersteigt.

**9.** Verfahren nach Anspruch 8, wobei der Schritt des Entfernens der Chromosomen das Paaren von Chromosomen, die durch den kleinsten genotypischen Abstand getrennt sind, und das Entfernen des Chromosoms aus dem Paar, welches die niedrigere Fitness hat, umfasst.

**10.** Verfahren nach Anspruch 1, wobei der Schritt des Anwendens von verschärfenden Restriktionen umfasst:

für jedes Fitnesskriterium, Identifizieren des schlechtesten Chromosoms für dieses Fitnesskriterium, Bestimmen eines Wertes eines vordefinierten endgültigen Restriktionsvektors (Final Constraints Vector, FCV), welcher diesem Fitnesskriterium entspricht, und Berechnen eines Quotienten des Wertes des FCV und des entsprechenden Fitnesswertes für das identifizierte schlechteste Chromosom;
Wählen des Fitnesskriteriums, welches den größten Quotienten aufweist,
Sortieren aller nicht dominierten Chromosomen nach diesem Fitnesskriterium,
Identifizieren eines vorgegebenen prozentualen Anteils der schlechtesten Chromosomen gemäß diesem Kriterium, und
Eliminieren der Chromosomen der identifizierten Hardwareelemente.

**11.** Verfahren nach Anspruch 10, welches das Aktualisieren eines aktuellen Restriktionsvektors (Current Constraints Vector, CCV) durch Setzen eines Wertes, der dem gewählten Fitnesskriterium entspricht, auf den entsprechenden Fitnesswert für das schlechteste Chromosom, das nach dem Eliminieren der identifizierten Chromosomen verbleibt, und das Verhindern, dass Chromosomen, deren ein oder mehrere Fitnesswerte schlechter als die entsprechenden Werte in dem CCV sind, als nicht dominiert markiert werden, umfasst.

**12.** Verfahren nach Anspruch 11, wobei jeder Wert des CCV nicht weiter verringert wird, sobald der Wert den entsprechenden Wert des FCV erreicht.

**13.** Verfahren nach einem der Ansprüche 1 bis 12, wobei die Wahl von Elternchromosomen auf der kombinierten Fitness der Chromosomen gemäß dem Fitnesskriterium basiert.

**14.** Verfahren nach Anspruch 13, wobei die kombinierte Fitness eine gewichtete Summe von Fitnesskriterien ist.

**15.** Verfahren nach einem der Ansprüche 1 bis 12, wobei die Wahl von Elternchromosomen auf der gemeinsamen Fitness basiert, in welcher die Fitness eines Chromosoms durch die Anzahl anderer Chromosomen, die eine Fitness-Nische besetzen, modifiziert ist.

**16.** Verfahren nach einem der Ansprüche 1 bis 12, wobei die Wahl von Elternchromosomen auf der Wahl von nicht dominierten Chromsomen und, wenn eine Auswahl zwischen nicht dominierten Chromosomen erfolgt, der kleinsten Nischen-Anzahl basiert.

**17.** Verfahren nach einem der Ansprüche 1 bis 12, wobei die Wahl von Elternchromosomen auf der Wahl von nicht dominierten Chromsomen und, wenn eine Auswahl zwischen nicht dominierten Chromosomen erfolgt, der Größe des Clusters, zu welchem die Individuen gehören, basiert.

**18.** Verfahren nach einem der Ansprüche 1 bis 17, wobei die Anwendung genetischer Operationen auf die Elternchromosomen eine Mutation der Chromosomen umfasst.

**19.** Verfahren nach einem der Ansprüche 1 bis 18, wobei die Anwendung genetischer Operationen auf die Elternchromosomen eine Kreuzung (Crossover) von Genen umfasst.

**20.** Verfahren nach Anspruch 19, wobei die Kreuzung ein Two-Point-Crossover umfasst.

**21.** Verfahren zum Umgestalten eines Digitalfilters nach einem der Ansprüche 1 bis 20, wobei die Schritte (a) und (b) das Erzeugen einer Population von Nachkommenchromosomen aus dem existierenden Hardwareelement durch Anwendung genetischer Operationen auf eine Chromosomendarstellung des Hardwareelements umfassen.

**22.** Verfahren nach einem der Ansprüche 1 bis 21, wobei die Chromosomen Genotypen aufweisen, die eine Pol-Nullstellen-Beschreibung des Filters umfassen.

**23.** Verfahren nach Anspruch 22, wobei der Chromosomen-Phänotyp die Übertragungsfunktion des Filters ist.

**24.** Computerprogramm, das auf einem Computer ausgeführt wird und den Computer veranlasst, das Verfahren nach einem der Ansprüche 1 bis 23 auszuführen.

**Revendications**

**1.** Procédé de conception d'un filtre numérique en utilisant un algorithme d'évolution, comprenant les étapes consistant à :

a) fournir une population initiale de fonctions de transfert de filtres numériques ;
b) coder chaque individu de la population initiale comme un chromosome ;
c) évaluer l'aptitude de chaque filtre numérique représenté dans la population en convertissant les gènes du chromosome représentant le filtre numérique en un phénotype et estimer le phénotype selon des critères d'aptitude multi-objectifs imposés par des contraintes techniques d'une application souhaitée du filtre numérique ;
d) sélectionner des chromosomes parents sur la base de l'évaluation d'aptitude de l'étape (c) ;
e) appliquer des opérations génétiques sur les chromosomes parents sélectionnés afin de produire des chromosomes enfants ;
f) sélectionner un jeu de chromosomes parmi les chromosomes parents et enfants afin de former des chromosomes d'une population d'une nouvelle génération de chromosomes ; comprenant :

- l'assignation de chaque chromosome parent et enfant à un d'une pluralité d'agrégats ;
- la formation d'un front Pareto de chromosomes non dominés à un d'une pluralité d'agrégats ; et
- l'application de contraintes restrictives comprenant la détermination des pires chromosomes pour chaque critère d'aptitude particulier et l'élimination desdits chromosomes des fronts Pareto des agrégats ;

g) répéter les étapes c) à f) indépendamment pour chaque agrégat de chaque nouvelle génération de chromosomes jusqu'à ce qu'un critère prédéterminé soit satisfait.

**2.** Procédé selon la revendication 1, dans lequel les étapes d'agrégation des chromosomes parent et enfant comprennent la formation d'agrégats sur la base de la distance entre les génotypes.

**3.** Procédé selon la revendication 1 ou 2, comprenant la réalisation d'une réagrégation après un nombre prédéterminé, n, de générations.

**4.** Procédé selon la revendication 3, dans lequel, à l'étape de réagrégation, un enfant ayant un parent unique ou deux parents dans le même agrégat est réagrégé dans l'agrégat parent, et d'autres enfants sont assignés à l'agrégat ayant le centre le plus proche.

**5.** Procédé selon la revendication 3 ou 4, dans lequel, pendant une phase d'exploitation, aucune réagrégation n'est effectuée sur un certain nombre de générations.

**6.** Procédé selon la revendication 3,4 ou 5, comprenant la formation d'un nouveau front Pareto pour chaque agrégat des chromosomes réagrégés.

**7.** Procédé selon un quelconque des revendications 1 à 6, dans lequel le nombre d'agrégats est fixe.

**8.** Procédé selon une quelconque des revendications 1 à 7, comprenant la suppression des chromosomes d'un front Pareto lorsque le nombre d'éléments matériels dans le front excède un seuil prédéterminé.

**9.** Procédé selon la revendication 8, dans lequel l'étape de suppression des chromosomes comprend l'appariement des chromosomes séparés par la distance génotypique la plus petite et la suppression du chromosome de la paire qui a l'aptitude la plus faible.

**10.** Procédé selon la revendication 1, dans lequel l'étape d'application de contraintes restrictives comprend les étapes consistant à :

pour chaque critère d'aptitude, identifier le pire chromosome pour ce critère d'aptitude, déterminer une valeur d'un vecteur de contrainte final (FCV) prédéfini qui correspond à ce critère d'aptitude et calculer un quotient de la valeur du FCV sur la valeur d'aptitude correspondante pour le pire chromosome identifié ;
sélectionner le critère d'aptitude qui a le plus grand quotient,
trier tous les chromosomes non dominés selon ce critère d'aptitude,
identifier un pourcentage prédéterminé des pires chromosomes selon ce critère, et
éliminer le chromosome des éléments matériels identifiés.

**11.** Procédé selon la revendication 10, comprenant la mise à jour d'un vecteur de contrainte actuel (CCV) en réglant une valeur correspondant au critère d'aptitude sélectionné sur la valeur d'aptitude correspondante pour le pire chromosome restant après l'élimination des chromosomes identifiés et l'empêchement des chromosomes dont une ou plusieurs valeurs d'aptitude sont pires que les valeurs correspondantes dans le CCV d'être marqués comme non dominés.

**12.** Procédé selon la revendication 11, dans lequel chaque valeur du CCV n'est pas réduite davantage une fois que la valeur atteint la valeur correspondante du FCV.

**13.** Procédé selon une quelconque des revendications 1 à 12, dans lequel la sélection des chromosomes parents est basée sur l'aptitude combinée des chromosomes selon les critères d'aptitude.

**14.** Procédé selon la revendication 13, dans lequel l'aptitude combinée est une somme pondérée des critères d'aptitude.

**15.** Procédé selon une quelconque des revendications 1 à 12, dans lequel la sélection des chromosomes parents est basée sur l'aptitude partagée dans laquelle l'aptitude d'un chromosome est modifiée par le nombre d'autres chromosomes occupant une niche d'aptitude.

**16.** Procédé selon une quelconque des revendications 1 à 12, dans lequel la sélection des chromosomes parents est basée sur la sélection des chromosomes non dominés et, quand la sélection se fait entre des chromosomes non dominés, le compte de niche le plus petit.

**17.** Procédé selon une quelconque des revendications 1 à 12, dans lequel la sélection des chromosomes parents est basée sur la sélection des chromosomes non dominés et, quand la sélection se fait entre des chromosomes non dominés, la taille de l'agrégat auquel les individus appartiennent.

18. Procédé selon une quelconque des revendications 1 à 17, dans lequel l'application des opérations génétiques sur les chromosomes parents comprend la mutation des chromosomes.

19. Procédé selon une quelconque des revendications 1 à 18, dans lequel l'application des opérations génétiques sur les chromosomes parents comprend la recombinaison par enjambement des gènes.

20. Procédé selon la revendication 19, dans lequel la recombinaison par enjambement comprend une recombinaison par enjambement en deux points.

21. Procédé de reconception d'un filtre numérique selon une quelconque des revendications 1 à 20, dans lequel les étapes (a) et b) comprennent la génération, à partir de l'élément matériel existant, d'une population de chromosomes enfants, en appliquant des opérations génétiques à une représentation chromosomale de l'élément matériel.

22. Procédé selon une quelconque des revendications 1 à 21, dans lequel les chromosomes ont des génotypes comprenant une description de pôle zéro du filtre.

23. Procédé selon la revendication 22, dans lequel le phénotype chromosomal est la fonction de transfert du filtre.

24. Programme informatique s'exécutant sur un ordinateur, amenant l'ordinateur à mettre en oeuvre le procédé selon une quelconque des revendications 1 à 23.

## Fig.1.

Download the bits into FPGAs

FPGAs with their architectures and functions specified

Evaluate the fitness of each FPGA through its interaction with the environment, select parents based on fitness

A population of chromosomes (architecture bits)

Selected parental chromosomes

Replace old chromosomes according to a replacement strategy

A population of offspring

Apply genetic operations, e.g. crossover and mutation, to the parents

## Fig.2.

Amplitude

0
Group delay

Omega    3.14

Passband    Transition band    Stopband

## Fig.3.

1. Generate the initial population $G(0)$ at random, and set $i = 0$;
2. REPEAT
    (a) Evaluate each individual in the population;
    (b) Select parents from $G(i)$ based on their fitness in $G(I)$;
    (c) Apply search operators to parents and produce offspring which form $G(i+1)$;
    (d) $i = i + 1$;
3. UNTIL 'termination criterion' is satisfied

# Fig.4.

# Fig.5.

# Fig.6.

## Fig.7.

## Fig.8.

## Fig.9.

## Fig.10.

## Fig.11.

## Fig.12.

# Fig.13.

# Fig.14.

# Fig.15.

# Fig.16.

# Fig.17.

EP 1 388 123 B1

Fig.18.

**EP 1 388 123 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **X. YAO.** Following the path of evolvable hardware. *Communications of the ACM,* 1999, vol. 42 (4), 47-49
- **X. YAO ; T. HIGUCHI.** Promises and challenges of evolvable hardware. *IEEE Trans. On Systems, Man, and Cybernetics, Part C: Applications and reviews,* 1999, vol. 29 (1), 87-97
- **LEE et al.** Digital filter design using genetic algorithm. *Advances in Digital Filtering and Signal Processing, 1998 IEEE Symposium,* 05 June 1998, 34-38
- **ZITZLER et al.** Multiobjective evolutionary algorithm: a comparative case study and the strength Parento Approach. *ffiEE Transactions on Evolutionary Computation,* November 1999, vol. 3 (4), 257-271
- **W.S. LU.** Design of Stable IIR filters with equiripple passbands and peak-constrained least-squares stop band. *IEEE Transactions on Circuits and Systems II: Analos and Digital Signal Processing,* 1999, vol. 46 (11), 1421-1426
- **A. ANTONION.** Digital Filters - Analysis, Design and Applications. McGraw Hill International, 1993
- **T.W. PARKS ; C.S. BURRUS.** Digital Filter Design. Topics in Digital Signal Processing. John Wiley and Sons, 1987
- **H-P SCHWEFAL.** Evolution and Optimum Seeking. John Wiley & Sons, 1995
- **D.B. FOGEL.** Evolutionary Computation: Towards a new Philosophy of machine intelligence. IEEE Press, 1995
- **D.E. GOLDBERG.** Genetic Algorithms in Search, Optimization and Machine learning. Reading, MA. Addison-Wesley, 1989